Europäisches Patentamt

European Patent Office

Office européen des brevets

(19)

(11)  EP 0 507 450 B1

(12)  EUROPEAN PATENT SPECIFICATION

(45) Date of publication and mention
of the grant of the patent:
**29.05.1996  Bulletin 1996/22**

(51) Int Cl.6: **H04N 7/01**, H04N 9/64,
H04N 9/04, H04N 9/79

(21) Application number: **92301828.7**

(22) Date of filing: **04.03.1992**

(54) **Digital colour television camera apparatus**

Digitale Farbfernsehkamera

Appareil de caméra de télévision en couleur numérique

(84) Designated Contracting States:
**DE FR GB**

(30) Priority:  06.03.1991  JP  63721/91
06.03.1991  JP  63720/91

(43) Date of publication of application:
**07.10.1992  Bulletin 1992/41**

(73) Proprietor: **SONY CORPORATION
Tokyo 141 (JP)**

(72) Inventors:
• **Miyamoto, Kazuyoshi, c/o Patents Division
Shinagawa-ku, Tokyo 141 (JP)**
• **Asaida, Takashi, c/o Patents Division
Shinagawa-ku, Tokyo 141 (JP)**

(74) Representative: **Cotter, Ivan John et al
D. YOUNG & CO.
21 New Fetter Lane
London EC4A 1DA (GB)**

(56) References cited:
**EP-A- 0 368 354          EP-A- 0 423 921**

• **SMPTE JOURNAL vol. 98, no. 11, November
1989, White Plains, pp. 823-829; PANTUSO:
'Reducing Financial Aliasing in HDTV
Production'**

## Description

This invention relates to digital colour television camera apparatus and to encoders for colour television cameras. Embodiments of the invention can be used to convert digital primary colour image signals generated in accordance with any one of predetermined television standards, such as NTSC or PAL standards, into either a digital component video signal (such as a D-1 video signal) or a digital composite video signal (such as a D-2 video signal).

A typical colour television camera includes an image pick-up device which produces three primary colour image video signals, such as red (R), green (G) and blue (B) signals. A luminance signal (Y) and colour difference signals are generated from the R, G and B colour video signals in accordance with a particular television standard with which the colour video camera is used. Typically, the television standard is the NTSC standard, the PAL standard, the SECAM standard, or another known television standard as used for broadcast purposes. Usually, one television camera is used to generate colour television signals in the NTSC standard, another used to generate colour television signals in the PAL standard, and so on.

In the NTSC standard, for example, the colour difference signals which are generated from the primary colour video signals are I and Q colour difference signals. In the PAL standard, the colour difference signals which are generated from the primary colour video signals are U and V colour difference signals. With reference to the NTSC standard, the relationship between the luminance signal Y and the colour difference signals I and Q is as follows:

$$Y = 0.30\ R + 0.59\ G + 0.11\ B$$
$$I = 0.60\ R - 0.28\ G - 0.32\ B$$
$$Q = 0.21\ R - 0.52\ G + 0.31\ B$$

In the PAL standard, the relationship between the luminance signal Y and the colour difference signals U and V is as follows:

$$Y = 0.30\ R + 0.59\ G + 0.11\ B$$
$$U = B - Y$$
$$V = R - Y.$$

In the NTSC standard, the I colour difference signal is constrained to a band of frequencies and exhibits a prescribed attenuation characteristic (referred to as a frequency band characteristic) such that the attenuation of the I signal at approximately 1.3 MHz is less then 2dB and the attenuation of the I signal at approximately 3.5 MHz is greater than 20 dB.

The Q colour difference signal of the NTSC standard exhibits a narrower bandwidth and a different frequency band characteristic. The attenuation of the Q signal at approximately 0.4 MHz is less than 2dB, its attenuation at approximately 0.5 MHz is less than 6dB and its attenuation at approximately 0.6 MHz is greater than 6dB.

In the PAL standard, the frequency band characteristics of the U and V colour difference signals are approximately the same and are constrained such that the attenuation thereof at approximately 1.3 MHz is less than 3dB and its attenuation at approximately 4 MHz is greater than 20dB.

In both the NTSC and PAL standards, the luminance signal Y and the colour difference signals I and Q (for the NTSC standard) or U and V (for the PAL standard) are produced by combining the primary colour video signals R, G and B in a matrix and then band-limiting the resultant colour difference signals by means of a low-pass filter whose filter characteristics conform to the aforementioned frequency band characteristics.

Typical colour television cameras use known solid-state image sensors having a discrete pixel structure constituted by charge coupled devices (CCDs) provided as the imaging section. The solid-state image sensor itself constitutes a sampling system for producing discrete samples of the colour video signals R, G and B, which samples can be used to produce either analogue or digital video signals. Because of this inherent sampling, aliasing components from the spatial sampling frequency $f_s$ which is used to sample the CCDs are mixed into the image pick-up output signals produced by the solid-state image sensor in a predictable manner.

It has been proposed to use a dual type CCD solid-state image sensor for forming the 3-colour image. In this dual type CCD sensor, one solid-state image sensor is used to produce the green colour image and the other solid-state image sensor is provided with colour coding light filters to produce the red and blue colour images. It also has been proposed to use three separate CCD image sensors, one for each colour. A so-called spatial offsetting technique for improving resolution in the latter arrangement is known. In this technique, the solid-state image sensor which produces the red colour image is offset from the solid-state image sensor which produces the green image by an amount equal to one-half the spatial pixel sampling period; and, likewise, the solid-state image sensor which produces the blue image is offset from the green image sensor by this same one-half spatial pixel sampling period. By using this spatial offsetting technique, a multichip solid-state image sensor may be used to produce an analogue output signal have high resolution that surpasses the restrictions inherent in the discrete number of pixels provided in the solid-state image sensor.

While a typical colour television camera produces analogue colour video signals at its output, it is desirable to provide a camera whose output signals are in digital form. Such digital video signals should be compatible with the standardized digital recording formats currently in use, such as the so-called 4:2:2 digital component format (referred to as the D-1 format) or the digital composite format (referred to as the D-2 format). In the D-1 format, the luminance signal Y produced by, for example, the usual matrix, is sampled at a sampling frequency 13.5 MHz; and this sampling frequency is the same for both the NTSC standard and the PAL standard. In addition, the sampling frequency of the colour difference signals is equal to 6.75 MHz (in both the NTSC and PAL standards). In the D-1 format, the sampled luminance and colour difference signals are linearly quantized, and each sample comprises eight bits. Heretofore, typically, the quantization levels of the luminance signals Y for the D-1 format in both the NTSC and PAL standards are such that the black level (0%) is assigned the quantization level of 16 and the white level (100%) is assigned the quantization level 235. In similar manner, the quantization levels of the colour difference signals for both the NTSC and PAL standards are such that the quantization level 128 represents the no signal level and the quantization level 225 represents the maximum level, such as in response to a 100% colour bar input.

In the D-2 format (which produces digital composite video signals), the luminance sampling frequency $f_s$ is equal to four times the chrominance sub-carrier frequency $f_{sc}$ ($f_s = 4f_{sc}$) for producing the digital composite video signal in both the NTSC and PAL standards. Of course, in the NTSC standard, $f_{sc} = 3.58$ MHz and in the PAL standard $f_{sc} = 4.43$ MHz. Thus, in the NTSC standard, the digitized video signals exhibit a clock frequency of 14.3 MHz and in the PAL standard, the digitized video signals exhibit a block frequency of 17.7 MHz. In addition, other sampling and clock frequencies have been adopted for the D-2 format when digitizing colour video signals in the PAL standard, namely a clock frequency equal to 908 times the horizontal scanning frequency $f_H$ ($f_s = 908 f_H$) or a clock frequency equal to 944 times the horizontal scanning frequency ($f_s = 944 f_H$). Thus, in the D-2 format, four different sampling clock frequencies have been used:

$$f_s = 4f_{sc} = 14.3 \text{ MHz for NTSC};$$
$$f_s = 4f_{sc} = 17.7 \text{ MHz for PAL};$$
$$f_s = 908 f_H \text{ for PAL; and}$$
$$f_s = 944 f_H \text{ for PAL.}$$

In the D-2 format, the video signal, including the synchronization and burst portions thereof, is linearly quantized; and each quantized sample is represented by eight bits. In hexadecimal notation, the 8-bit quantization of the video signal for the black level (0%) is 3c and for the white level (100%) is c8. 8-bit quantization of the sync tip level in hexadecimal notation is 04.

One example of colour television apparatus which produces digital video signals in accordance with the foregoing sampling clock frequencies and quantization levels is described in our US patent US-A-5 095 364. Document EP-A-0 368 354 discloses a signal processing circuit for a digital colour television camera which produces a component signal of a first television standard and a composite signal of a second television standard.

Although it is desirable to provide a signal colour television camera capable of producing digital video signals in either the D-1 or D-2 formats for either the NTSC or PAL (or other) standards, certain difficulties in implementing a practical design are evident. For example, different sampling frequencies are used for the D-1 and D-2 formats, and even in the D-2 format, different sampling frequencies are used to digitize video signals in the PAL standard. Also, the quantizing values which are used to represent particular reference levels in the D-1 and D-2 formats, as well as in the NTSC and PAL standards, differ from each other, as mentioned above. Accordingly, it has been thought, heretofore, that different encoder circuits were needed to encode NTSC video signals in the D-1 format, to encode NTSC video signals in the D-2 format, to encode PAL video signals in the D-1 format, and to encode PAL video signals in the D-2 format. It will be appreciated that if separate discrete encoder circuits are used to accommodate the D-1 and D-2 formats for encoding either NTSC or PAL video signals, a complex and expensive colour television camera will result. Furthermore, since the frequency band characteristics of the colour difference signals in the NTSC standard (for example, I and Q signals) differ from the frequency band characteristics of the colour difference signals in the PAL standard (for example, the U and V signals), the requisite band limiting operation which is used to minimize aliasing effects will require different low-pass filter processing for the NTSC and PAL standards. Even when implemented by digital circuitry, such low-pass filter processing is complex and expensive if different digital processing circuits must be used to band-limit the NTSC colour difference signals and the PAL colour difference signals.

Therefore, it had been thought to be complicated, expensive and, thus, impractical, to design a common colour television camera that can be used to digitize both NTSC and PAL colour video signals in both the D-1 and D-2 formats. Rather, at best, separate colour television cameras were used, depending upon the digital format in which the digitized video signals are encoded and the particular television standard (for example, NTSC or PAL) with which the digitized video signals are to be used.

According to the present invention there is provided digital colour television camera apparatus for selectively producing either a digital component video signal or a digital composite video signal, the apparatus comprising:

image means for providing digital primary colour image signals;

encoding means coupled to receive said digital primary colour image signals and operable in a first mode to encode said digital primary colour image signals to produce a digital component video signal, and in a second mode to encode said digital primary colour image signals to produce a digital composite video signal; and

level setting means included in said encoding means and operable when said encoding means operates in said first mode for establishing predetermined quantizing values to represent respective reference levels of said digital component video signal, said level setting means being operable when said encoding means operates in said second mode for establishing different predetermined quantizing values to represent respective reference levels of said digital composite video signals.

According to the present invention there is also provided digital colour television camera apparatus for selectively producing either a digital component video signal or a digital composite video signal in accordance with either a first or a second television standard, the apparatus comprising:

image means for providing digital primary colour image signals at a predetermined sampling clock rate $2f_s$ from which said digital component or digital composite video signal is derived;

matrix means coupled to receive said digital primary colour image signals at said sampling clock rate for producing colour difference signals therefrom at said sampling clock rate;

down sampling means coupled to said matrix means for down sampling at least one of the colour difference signals to reduce the sampling clock rate thereof; and

digital low-pass filtering means operable in accordance with said first television standard to limit the frequency band of the down-sampled colour difference signal by providing predetermined selected attenuation at pre-established frequencies of the down-sampled colour difference signal, said digital low-pass filtering means being operable in accordance with said second television standard to limit the frequency band of the down-sampled colour difference signal by providing predetermined selected attenuation at different pre-established frequencies of the down-sampled difference signal, thereby producing a band-limited colour difference signal for said digital composite video signal.

According to the present invention there is also provided a common encoder for a colour television camera operable in accordance with first or second television standards to selectively encode digital primary colour image signals at a sampling clock rate into digital component or digital composite video signals, said encoder comprising:

luminance signal generating means for combining the digital primary colour image signals to generate a luminance signals therefrom;

level setting means for establishing predetermined quantizing values for said luminance signal to represent respective reference levels of the digital component and digital composite video signals when the colour television camera operates in accordance with said first or second television standard;

matrix means for combining the luminance signals and at least predetermined ones of said digital primary colour image signals to produce colour difference components at said sampling clock rate;

first colour difference signal means coupled to receive and selectively produce from the colour difference components first digital colour difference signals in accordance with said first or second television standard;

first down sampling means for providing the first digital colour difference signals with a clock rate reduced from said sampling clock rate;

first low-pass filter means for frequency band limiting selected ones of the reduced clock rate first colour difference signals in said first and second television standards;

second colour difference signal means for combining the digital primary colour image signals to generate a predetermined digital colour difference signal in accordance with said first television standard;

second down sampling means for down sampling the predetermined digital colour difference signal to a clock rate less than said sampling clock rate;

second low-pass filter means for frequency band limiting either the down-sampled predetermined digital colour difference signal or one of the digital colour difference signals of reduced clock rate produced in accordance with said second television standard; and

modulating means for modulating a sub-carrier with the band limited colour difference signals provided by said first and second low-pass filter means for use in said digital composite video signal.

Embodiments of the present invention provide digital colour television camera apparatus for producing digital video signals in different formats, such as digital component or digital composite video signals, in accordance with different television standards, such as NTSC or PAL standards, or a common encoder for producing either digital component or digital composite video signals in accordance with either NTSC or PAL (or other) standards.

Embodiments of the invention may include level setting means to establish different quantizing values for representing different video signal reference levels in each of the operable digital formats (for example both digital component and digital composite video formats). For example, different quantizing values representing white and black levels as well as 0% and ± 100% colour levels are established by the level setting means.

An embodiment of the invention may comprise digital colour television camera apparatus with a common encoder for encoding into a selected one of a plurality of digital formats (for example the D-1 digital component video signal or the D-2 digital composite video signal) colour television signals that are presented in any one of a plurality of different television standards (for example colour video signals in the NTSC or PAL standards). The common encoder is operable in a first mode to encode digital primary colour image signals (for example digitized R, G and B signals) to produce a digital component video signal (that is, the D-1 format) and in a second mode to encode the digital primary colour image signals to produce a digital composite video signal (that is, the D-2 format). The encoder includes a level setting means for establishing predetermined quantizing values to represent respective reference signal levels of the digital component video signal (that is, particular quantizing values are assigned to video reference levels in the D-1 format), and to represent reference levels in the digital composite video signal (that is, different quantizing values are assigned to video reference levels in the D-2 format).

The encoder may include a matrix which combines the digital primary colour image signals that had been sampled at a clock rate $2f_s$ to produce colour difference signals at that clock rate; and the colour difference signals are down-sampled to reduce the clock rate thereof. The down-sampled colour difference signals are filtered by a digital low-pass filter which operates in accordance with a first television standard (for example NTSC) to band-limit the down-sampled colour difference signals by providing selected attenuations at pre-established frequencies. The digital low-pass filter operates in accordance with a second television standard (for example PAL) to band-limit the down-sampled colour difference signals by providing different attenuations at different frequencies. By down sampling the colour difference signal, and particularly the Q signal of the NTSC standard, the complexity of the digital low-pass filter is significantly reduced. The digital low-pass filter operates at different clock rates, depending upon whether the digital component or digital composite (for example D-1 or D-2) video signals are produced.

The invention will now be described by way of example with reference to the accompanying drawings, throughout which like parts are referred to by like references, and in which:

Figure 1 is a block diagram of colour television camera apparatus in which embodiments of the present invention find application;

Figure 2 is a diagrammatic view showing an array of solid-state image sensors used in the apparatus of Figure 1;

Figures 3A to 3H are graphical representations of signal spectra for explaining the operation of the apparatus of Figure 1 in accordance with the NTSC standard;

Figures 4A to 4H are graphical representations of signal spectra for explaining the operation of the apparatus of Figure 1 in accordance with the PAL standard;

Figure 5 is a block diagram of an encoder which embodies the present invention;

Figure 6 illustrates a filter characteristic for band-limiting an NTSC colour difference signal I and a PAL colour difference signal V by a common low-pass filter of Figure 5;

Figure 7 is a block diagram of one implementation of the low-pass filter;

Figure 8 illustrates a filter characteristic for band-limited an NTSC colour difference signal Q or a PAL colour difference signal U by another common low-pass filter of Figure 5;

Figure 9 is a block diagram of one implementation of the other low-pass filter; and

Figure 10 is a block diagram representing the first stage 39A of the low-pass filter implementation of Figure 9.

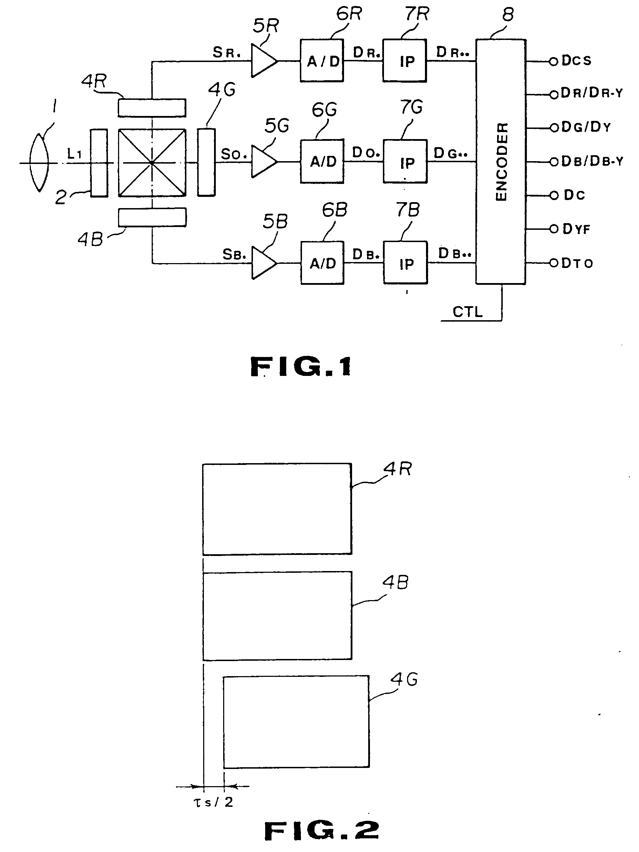

Referring first to Figure 1, there is illustrated a block diagram of a digital colour television camera in which embodiments of the present invention find application. The colour television camera has three solid-state image sensors in which imaging light $L_1$ incident from an imaging lens 1 via an optical low-pass filter 2 is separated by a colour separating prism 3 into three primary colour components for imaging three primary colour images of an object on three CCD image sensors 4R, 4G and 4B. The individual colour image signals produced by the image sensors 4R, 4G and 4B form red, green and blue (R, G and B) colour components from which colour video signals may be produced in accordance with a desired television standard, such as NTSC or PAL.

In this embodiment, the CCD image sensors 4R, 4G and 4B constitute the imaging section of the colour television camera and are so arrayed that the CCD image sensor 4R from which the red colour component is produced is offset with respect to the CCD image sensor 4G from which the green colour component is produced by one-half the spatial sampling period $\tau_s$ or $1/2 \tau_s$, as shown in Figure 2. Likewise, the CCD image sensor 4B for producing the blue colour component is also offset by $1/2 \tau_s$ with respect to the green image sensor 4G. The three CCD image sensors 4R, 4G and 4B are driven by a CCD driving circuit, not shown, so that the imaging charges of the pixels are read by readout clock signals of a sampling frequency $f_s$ which is four times the colour sub-carrier frequency $f_{sc}$ ($f_s = 4f_{sc}$).

The colour television camera apparatus of Figure 1 operates in accordance with the NTSC or PAL standard to produce digital component colour video signals in accordance with the D-1 format or to produce digital composite colour video signals in accordance with the D-2 format. It will be appreciated that it also may be operable in accordance with other known television standards, such as SECAM. When operating in accordance with the NTSC standard to produce digital component video signals (that is the D-1 format), the imaging charges of the pixels produced by the respective CCD image sensors are read out at a sampling frequency $f_s = 13.5$ MHz. When the image sensors are driven to produce R, G, B colour components for producing digital composite video signals (that is the D-2 format), the image sensors are driving at a sampling frequency $f_s = 4f_{sc} = 14.3$ MHz.

When the colour television camera apparatus operates in accordance with the PAL standard, the CCD image sensors are driven at a read-out sampling clock frequency $f_s = 13.5$ MHz when the R, G, B colour components are digitized to produce digital component colour video signals (that is the D-1 format). However, when the colour components are digitized to produced digital composite colour video signals (that is the D-2 format) in accordance with the PAL standard, the three image sensors are driven at the sampling clock frequency $f_s = 4f_{sc} = 17.7$ MHz. Consistent with other implementations of digitizing formats, such as the D-2 format, the image sensors 4R, 4G and 4B may be driven with read-out clock signals at the sampling frequency $f_s = 908f_H$ or $f_s = 944f_H$, where $f_H$ is the horizontal scanning frequency of the PAL standard.

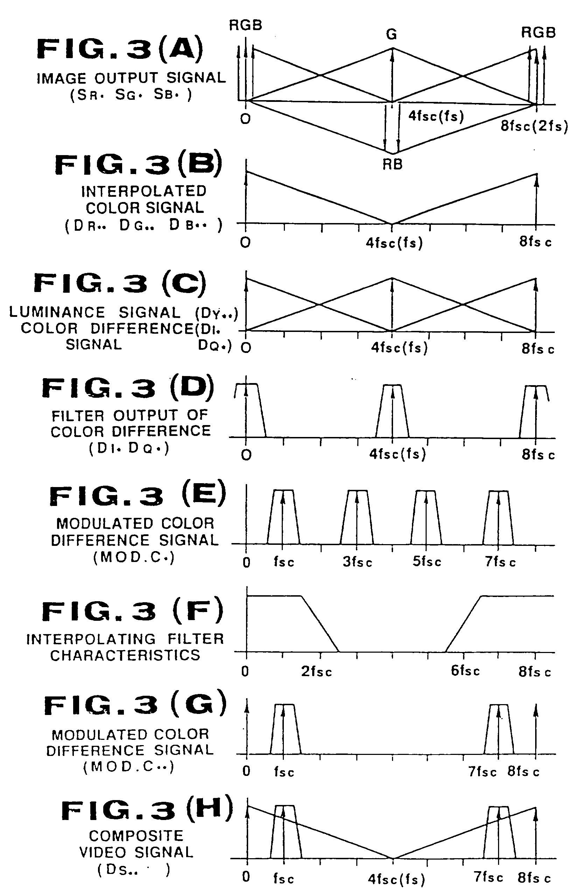

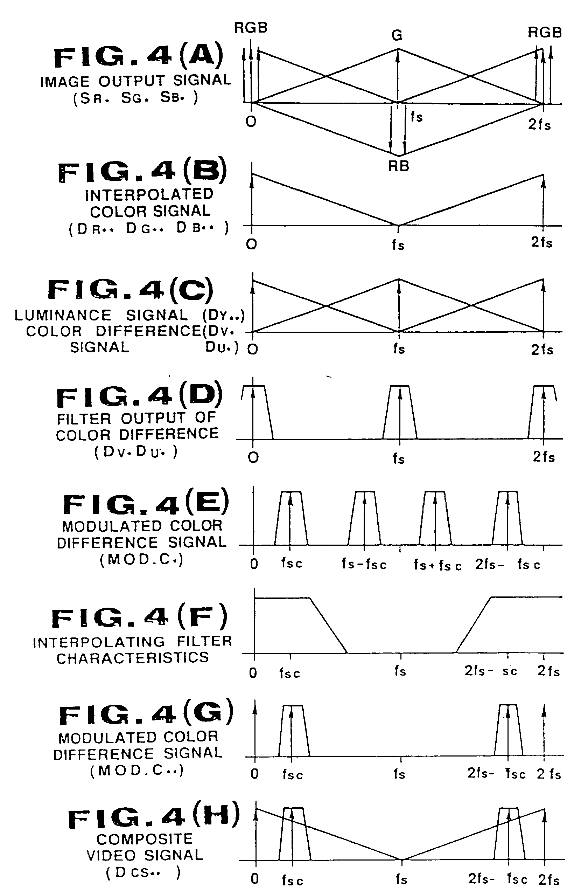

When the CCD image sensors 4R, 4B and 4G are arranged with spatial offsetting as shown in Figure 2, spatial samplings of the three primary colour images derived from an object image are produced such that the red image is offset from the green image by $\tau_s/2$ and the blue image also is offset from the green image by $\tau_s/2$. Thus, when the green image is sampled at the sampling frequency $f_s$ to produce a sampled green image signals $S_{G*}$, and the red and blue images are sampled at the sampling frequency $f_s$ to produce sampled red and blue image signals $S_{R*}$ and $S_{B*}$, the sampled green image signals are in anti-phase relative to the sampled red and blue image signals, such as shown in the spectra of the primary colour image signals illustrated in Figure 3A (which represents the NTSC standard) and in Figure 4A (which represents the PAL standard). More particularly, Figure 3A represents the spectra of the sampled R, G, B signals to be digitized in either the D-1 or D-2 format in accordance with the NTSC standard; and Figure 4A likewise represents the spectra of the sample R, G, B signals to be digitized in either the D-1 or D-2 format in accordance with the PAL standard.

The image pick-up output signals $S_{R*}$, $S_{G*}$ and $S_{B*}$, read out from CCD image sensors 4R, 4G and 4B by read out clock signals at the sampling frequency $f_s$, are coupled to analogue/digital converters (ADCs ) 6R, 6G and 6B via buffer amplifiers 5R, 5G and 5G, respectively. Although not shown, each of the ADCs 6R, 6G and 6B is supplied from a timing generator with clock signals having the clock frequency (or repetition rate) $f_s$. Thus, each ADC 6R, 6G and 6B is supplied with a clock signal whose frequency is equal to that of the read out sampling clock signals supplied to the respective CCD image sensors 4R, 4G and 4B. The ADCs 6R, 6G and 6B directly digitize the sampled colour pickup signals $S_{R*}$, $S_{G*}$ and $S_{B*}$ at the clock rate $f_s$ to produce digital colour signals $D_{R*}$, $D_{G*}$ and $D_{B*}$, respectively, having output spectra which are the same as the spectra of the colour image signals $S_{R*}$, $S_{G*}$ and $S_{B*}$ shown in Figures 3A and 4A. Here, the ADCs 6R, 6G and 6B quantize the colour image pick-up signals linearly and produce 10-bit samples in which the 0% level is assigned the quantizing value 32, and the 100% level is assigned the quantizing level 856. Since the frequency of the clock signals supplied to the ADCs 6R, 6G and 6B is equal to the frequency of the read-out clock signals supplied to the CCD image sensors 4R, 4G and 4B, the clock rate (or repetition rate) of the digital primary colour image signals $D_{R*}$, $D_{G*}$ and $D_{B*}$ is determined by the sampling clock frequency $f_s$, and thus is determined as a function of whether digital component or digital composite video signals are produced and whether those signals conform to the NTSC or PAL standard.

The digital primary colour image signals $D_{R*}$, $D_{G*}$ and $D_{B*}$ produced by the ADCs 6R, 6G and 6B, are coupled to interpolating sections 7R, 7G and 7B, respectively. The interpolating sections interpolate the digital primary colour image signals which exhibit the clock rate $f_s$ to produce digital colour signals $D_{R**}$, $D_{G**}$ and $D_{B**}$ having the clock rate $2f_s$ (that is twice the clock rate $f_s$). It will be recognized that, in the present description, for convenience, a single asterisk (*) represents a clock rate $f_s$ and a double asterisk (**) represents the clock rate $2f_s$. The resultant digital colour signals $D_{R**}$, $D_{G**}$ and $D_{B**}$ produced by the interpolating sections 7R, 7G and 7B, respectively, exhibit the frequency spectrum shown in Figures 3B and 4B (in accordance with the NTSC and PAL standards, respectively).

It will be noted that the three primary colour image signals $S_{R*}$, $S_{G*}$ and $S_{B*}$ derived from CCD image sensors 4R, 4G and 4B cannot be arithmetically operated upon directly since the green colour image signal $S_{G*}$ is phase-offset by $\pi$ from both the red colour image signal $S_{R*}$ and the blue colour image signals $S_{B*}$, as described previously and as shown in Figure 2. But, by increasing the clock rate of these colour image signals in interpolating sections 7R, 7G and 7B, the digital colour signals $D_{R**}$, $D_{G**}$ and $D_{B**}$ are converted into phase-matched digital colour signals at the $2f_s$ rate. Now that these digital colour signals are phase-matched, they may be digitally processed directly. As an alternative to this interpolation, the CCD image sensors may be provided with a number of pixels that is sufficiently large to assure high resolution without resorting to the spatial offsetting shown in Figure 2. In that event, the primary colour image signals $S_R$, $S_G$ and $S_B$ may be sample at the $2f_s$ rate directly by the ADCs 6R, 6G and 6B, resulting in phase-matched digital colour signals $D_{R**}$, $D_{G**}$ and $D_{B**}$.

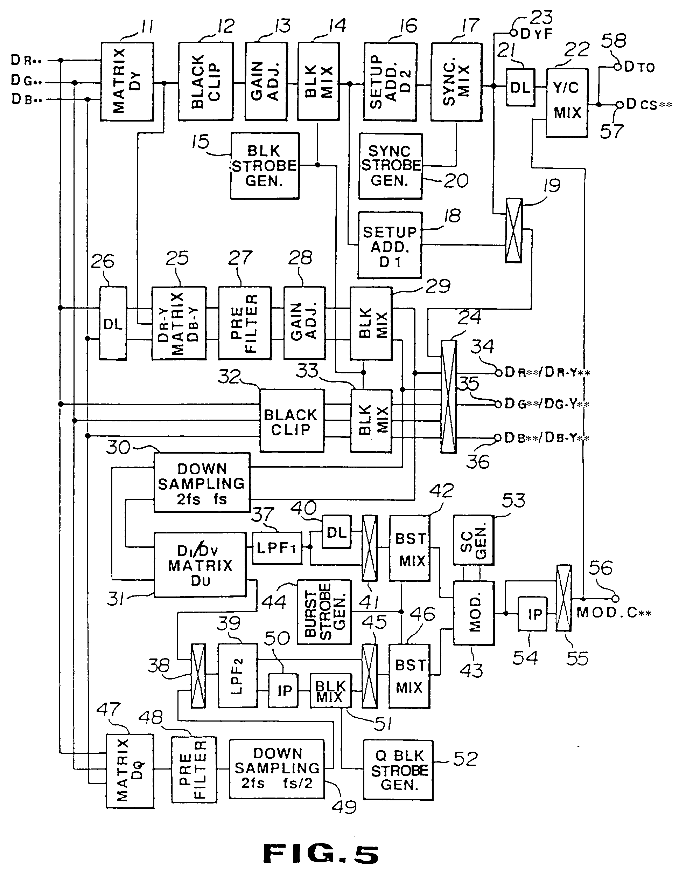

The digital colour signals $D_{R**}$, $D_{G**}$ and $D_{B**}$ produced by the interpolating sections 7R, 7G and 7B at the $2f_s$ rate are supplied to an encoder 8. The encoder 8 operates in different encoding modes to encode the digital colour signals supplied thereto into either digital component video signals (for example the D-1 format) or digital composite video signals (for example the D-2 format) in accordance with either the NTSC or PAL standards (or other television standards that may be preferred). the encoder is illustrated in Figure 5 and includes a luminance section, a red and blue colour difference section, and a colour difference (I-Q, U-V) section. The luminance section includes a matrix 11 supplied with digital primary colour image signals $D_{R**}$, $D_{G**}$ and $D_{B**}$ and combines these signals to produce a digital luminance signal $D_{Y**}$. The digital luminance signal $D_{Y**}$ is supplied to the red and blue colour difference section and also to a black level clipping circuit 12, which clips the digital luminance signal to the black level. The clipped digital luminance signal is then supplied to a blanking mixer 14 by way of a level setting circuit 13, also referred to herein as a gain adjuster.

The level setting circuit, or gain adjuster 13, establishes and assigns predetermined quantizing values to different reference levels included in the digital luminance signal $D_{Y**}$, depending upon whether the illustrated encoder is operating to produce digital component video signals (the D-1 format) or digital composite video signals (the D-2 format; and whether these digital video signals are consistent with the NTSC or PAL standard. For example, if the encoder operates to produce digital component video signals (the D-1 format), the level setting circuit 13 operates to produce 8-bit samples of the digital luminance signal $D_{Y**}$, whether the digital luminance signal is intended to represent NTSC or PAL standards, and the quantizing value 235 is assigned to the white level (100%) while the quantizing value sixteen is assigned to the black level (0%). However, if the encoder is operating to produce digital composite video signals (the D-2 format), then the level setting circuit 13 produces 10-bit digital samples; and if the digital composite video signal is produced in accordance with the NTSC standard, then the level setting circuit assigns the quantizing value 800 to the 100% level, the quantizing value 240 to the 0% level and the quantizing value sixteen to the sync tip level. However, if the digital composite video signal is produced by the encoder in accordance with the PAL standard, then the level setting circuit 13 assigns the 10-bit quantizing value 816 to the 100% level, the quantizing value 256 to the 0% level and the quantizing value sixteen to the sync tip level.

The blanking mixer 14 is supplied with blanking data generated by a blanking strobe generator 15 and mixes this blanking data with the digital luminance signal $D_{Y**}$ to whose reference levels predetermined quantizing values have been assigned by the level setting circuit 13 as just described. The resultant digital luminance signal $D_{Y**}$ into which blanking data has been inserted by the blanking mixer 14 is coupled to a synchronizing signals mixer 17 by a set-up circuit 16, and this digital luminance signal is also supplied to a selector 19 by way of another set-up circuit 18. The set-up circuit 16 inserts standardized set-up data used in the D-2 format (forming no part of the present invention per se) into the blanking data that had been provided by the blanking mixer 14. The resultant digital luminance signal $D_{Y**}$, now represented in the D-2 format, synchronizing data generated by a sync strobe 20 inserted therein by the synchronizing signal mixer 17.

The output of the synchronizing signals mixer 17, namely, the digital luminance signal $D_{Y**}$ containing sync data, is coupled to another input of selector 19 and also to a luminance/chrominance (Y/C) mixer 22 by way of a delay circuit 21. This digital luminance signal $D_{Y**}$ also is coupled directly to an output terminal 23 which is used as a monitor output to supply luminance data $D_{YF}$ to a viewfinder of the camera. As will be described below, a modulated colour signal MOD.C**, having a clock frequency at the $2f_s$ rate, is also supplied to the Y/C mixer 22 for mixing with the digital luminance signal $D_{Y**}$ to produce a digital composite video signal $D_{CS**}$ which is supplied to an output terminal 57.

As mentioned above, and as shown in Figure 5, the digital luminance signal $D_{Y**}$ having blanking data inserted therein, is supplied from the blanking mixer 14 to the set-up circuit 18. The set-up circuit 18 inserts into the blanking data now included in the digital luminance signal, set-up data that typically are used in accordance with the D-1 format. These set-up data and the operation of the set-up circuit 18 form no part of the present invention per se.

The selector 19 which is coupled to the synchronizing signal mixer 17 and to the set-up circuit 18 operates in accordance with the D-1 format or the D-2 format to select either the digital luminance signal $D_{Y**}$ which includes the D-1 set-up data provided by the set-up circuit 18 or the digital luminance signal $D_{Y**}$ which contains the D-2 set-up data provided by the set-up circuit 16 plus the sync data provided by the synchronizing signal mixer 17 to another selector 24. As will be described, the selectors 19 and 24 (as well as the other selectors shown in Figure 5) operate as selector switches and the selector 24 provides at its output either digital primary colour image signals $D_{R**}$, $D_{G**}$ and $D_{B**}$, supplied thereto through a black level clipping circuit 32 and a blanking mixer 33 (the latter being similar to the blanking mixer 14 and being supplied with blanking data from the blanking strobe generator 15), or red and blue colour difference components $D_{R-Y**}$, $D_{B-Y**}$, supplied from the red and blue colour difference section, plus the digital luminance signal $D_{Y**}$. The digital primary colour signals provided by the selector 24 may be supplied to and used by other apparatus (not shown) for further processing or for conversion into analogue signals, as may be desired. The digital colour difference component and digital luminance signal provided at output terminals 34 to 36 of the selector 24 comprise the digital component (D-1) video signals.

The red and blue colour difference section includes a colour difference matrix 25 supplied with the digital red and blue image signals $D_{R**}$ and $D_{B**}$ by way of a delay circuit 26. It will be appreciated that the delay circuit 26 simply functions to compensate for delays inherent in the other circuitry included the illustrated encoder. The matrix 25 is also supplied with the digital luminance signal $D_{Y**}$ produced by the matrix 11. It will be appreciated that the matrix 25 operates in known manner to produce the digital red and blue colour difference components $D_{R-Y**}$ and $D_{B-Y**}$ from the digital red and blue components and the digital luminance signal supplied thereto. These digital colour difference components $D_{R-Y**}$ and $D_{B-Y**}$ are supplied to a blanking mixer 29 via a pre-filter 27 and a level setting circuit, or gain adjuster 28. When the encoder operates to produce digital component video signals (the D-1 format), the level setting circuit 28 assigns a quantizing thereto of 240 corresponding to a +100% level, a quantizing level of 128 corresponding to the 0% level and a quantizing value of sixteen corresponding to the -100% level. Conversely, when the encoder operates to produce digital composite video signals (the D-2 format), the quantizing values assigned to the 10-bit samples of the digital colour difference components supplied to level setting circuit 28 are, for the NTSC standard, a quantizing value of 800 corresponding to a 100% level, a quantizing value of 240 corresponding to a 0% level and a quantizing value of sixteen corresponding to the sync tip level. However, if the digital composite video signals are encoded in accordance with the PAL standard, then the quantizing values assigned to the respective reference levels of the digital colour difference components supplied to the level setting circuit 28 are such that the 100% level is assigned the quantizing value 816, the 0% level is assigned the quantizing value 256 and the sync tip level is assigned the quantizing value 16.

The gain-adjusted colour difference components provided at the output of the level setting circuit 28 are supplied through the blanking mixer 29 to the selector 24 as digital colour difference components $D_{R-Y**}$ and $D_{B-Y**}$, respectively. The blanking mixer 29 inserts blanking data produced by the blanking strobe generated 15 into the gain-adjusted colour difference components provided by the level setting circuit 28. These colour difference components, including the blanking data, are also coupled to the colour difference section of the encoder by way of a down sampling circuit 30.

The colour difference section includes a matrix 31 which produces colour difference signals in accordance with either the NTSC standard or the PAL standard. When the encoder operates in accordance with the NTSC standard, the matrix generates the usual I colour difference signals; and when the encoder operates in accordance with the PAL standard, the matrix generates the usual U and V colour difference signals. As will be described, the colour difference signals produced by the matrix 31 subsequently are band-limited to reduce the bandwidth occupied by these digital colour difference signals. To minimize the complexity and, thus, the hardware needed for such band-limiting processing, the clock rate of the colour difference signals produced by matrix 31 is reduced from the $2f_s$ rate of the colour difference components originally produced by the matrix 25. This preferable reduction in clock rate is achieved by the down sampling circuit 30, which is a known device and which, in the present embodiment, converts the clock rate of the digital colour components $D_{B-Y**}$ and $D_{R-Y**}$ from $2f_s$ to $f_s$. Thus, the down sampling circuit 30 operates in known manner to supply to the matrix 31 the down-sampled colour difference components $D_{R-Y*}$ and $D_{B-Y*}$. The matrix 31 is provided with two outputs, and operates in accordance with the NTSC standard to produce, at its upper output (as illustrated in Figure 5), the NTSC digital colour difference signal $D_{I*}$. When the encoder operates in accordance with the PAL standard, the matrix 31 combines the colour difference components $D_{R-Y*}$ and $D_{B-Y*}$ to produce PAL digital colour difference signals $D_{U*}$ and $D_{V*}$; wherein the digital colour difference signal $D_{U*}$ is provided at the lower output of matrix 31 (as seen in Figure 5) and the digital colour difference signal $D_{V*}$ is provided at the upper output of the matrix 31.

Band-limiting of the NTSC colour difference signal $D_{I*}$ or the PAL colour difference signal $D_{V*}$ is provided by a low-pass filter 37. As will be described further below, the PAL colour difference signal $D_{U*}$ is also subjected to a band-limiting operation; but this is carried out by another low-pass filter 39.

The band-limited processing of the digital colour difference signal $D_{I*}$ or $D_{V*}$ is graphically illustrated in Figure 6. In particular, the low-pass filter 37 has a transfer characteristic to attenuate the NTSC digital colour difference signal $D_{I*}$ by less than 3dB at approximately 1.3 MHz, and to attenuate the PAL digital colour difference signal $D_{V*}$ by more than 20dB at approximately 4 MHz. This band-limiting processing thus reduces the effective band width of the colour difference signals to a more useful, practical range for further transmission, recording or processing in either the D-1 or D-2 format.

The transfer characteristic of the low-pass filter 37 is as follows:

$$H_{37}(z) = \frac{1}{2^8} (z^{-2}+2z^{-1}+1)^2 (z^{-4}+2z^{-2}+1)$$

$$x(-z^{-6}+2z^{-4}+2z^{-3}+2z^{-2}-1) \tag{1}$$

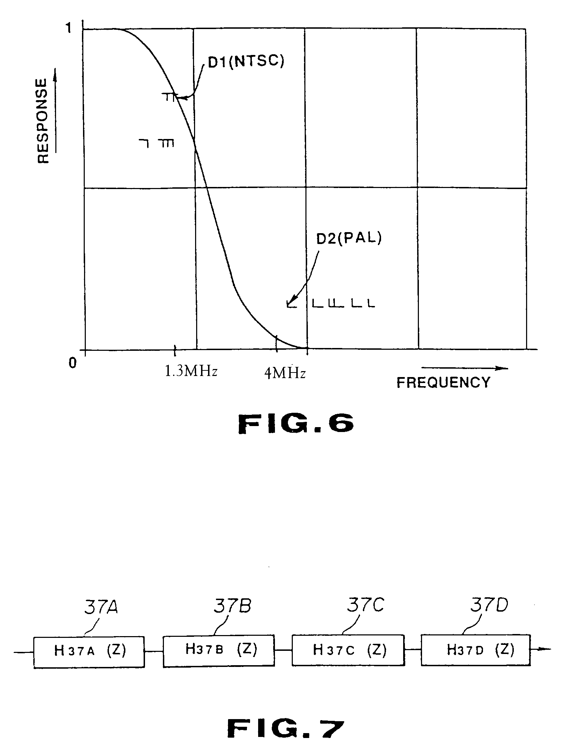

This transfer characteristic may be implemented by cascaded filter blocks 37A, 37B, 37C and 37D, as illustrated in Figure 7. In particular, the filter block 37A processes either the NTSC digital colour difference signal $D_{I*}$ or the PAL digital colour difference signal $D_{V*}$ in accordance with the following transfer function:

$$H_{37A}(z) = \frac{1}{2^2} \, (-z^{-6} + 2z^{-4} + 2z^{-3} + 2z^{-2} - 1) \qquad (2)$$

The processed colour difference signal provided by the filter block 37A is further processed by the filter block 37B, which has the following transfer function:

$$H_{37B}(z) = \frac{1}{2^2} \, (z^{-4} + 2z^{-2} + 1) \qquad (3)$$

The resultant digital colour difference signal processed by the filter block 37B is further processed by the filter block 37C in accordance with the following transfer function:

$$H_{37C}(z) = \frac{1}{2^2} \, (z^{-2} + 2z^{-1} + 1) \qquad (4)$$

Finally, the filter block 37D provides further processing of the processed digital colour difference signal supplied thereto by the filter block 37C in accordance with the following transfer function:

$$H_{37D}(z) = \frac{1}{2^2} \, (z^{-2} + 2z^{-1} + 1) \qquad (5)$$

The band-limited digital colour difference signal $D_{I^*}$ or $D_{V^*}$ is selected by a selector 41, depending upon whether the encoder 8 operates in accordance with the NTSC or PAL standard. The NTSC digital colour difference signal $D_{I^*}$ is supplied to the selector 41 by a delay circuit 40 which compensates for inherent time delays imparted to the digital colour difference signal $D_{Q^*}$, as will be described. Such additional time delays are not added to the digital colour difference signal $D_{U^*}$ and, thus, the band-limited PAL digital colour difference signal $D_{V^*}$ is supplied from the low-pass filter 37 to the selector 41 directly.

The selector 41 is coupled to a modulator 43 via a burst mixer 42 to supply to the modulator 43 either the band-limited NTSC colour difference signal $D_{I^*}$ or the band-limited PAL colour difference signals $D_{V^*}$. The burst mixer 42 is coupled to a burst strobe generator 44 and inserts burst data into the digital colour difference signal supplied thereto from the selector 41. It is appreciated that these inserted burst data are compatible with the NTSC standard when the selector 41 supplies digital colour difference signal $D_{I^*}$; and these burst data are compatible with the PAL standard when the selector 41 supplies the colour difference signal $D_{V^*}$.

Before describing the operation of the modulator 43, reference is now made to the manner in which the NTSC digital colour difference signal $D_Q$ is produced and processed, and the manner in which the PAL colour difference signal $D_U$ is processed. The NTSC colour difference signal $D_Q$ is produced by a matrix 47 which, as shown in Figure 5, combines the digital primary colour image signals $D_{R^{**}}$, $D_{G^{**}}$ and $D_{B^{**}}$, each exhibiting the clock rate $2f_s$, thus producing the digital colour difference signal $D_{Q^{**}}$, also at the clock rate $2f_s$. This digital colour difference signal $D_{Q^{**}}$ is band-limited and thus constricted to a relatively narrow bandwidth which, it will be appreciated, is sufficient for transmission, recording or further processing of the digital colour difference signal $D_Q$, even when using the D-1 or D-2 format. The low-pass filter 39, to be described, band-limits the digital colour difference signal $D_Q$; and to reduce the complexity of the low-pass filter 39, and thereby minimize the amount of hardware needed to implement it, the clock rate of the digital colour difference signal $D_{Q^{**}}$ is reduced from $2f_s$ to $f_s/2$ by a down sampling circuit 49. As shown, the digital colour difference signal $D_{Q^{**}}$ is supplied from the matrix 47 to the down sampling circuit 49 by a pre-filter 48. The down sampling circuit 49 is of known design and operates in a manner known. The resultant, down-sampled digital colour difference signal $D_Q$ is coupled to the low-pass filter 39 by a selector 38. The selector 38 is coupled to the matrix 31 and supplies to the low-pass filter 39 either the down-sampled NTSC colour difference signal $D_Q$ from the down sampling circuit 49 or the PAL colour difference signal $D_{U^*}$ from the matrix 31, depending upon whether the encoder 8 is operating in accordance with the NTSC or PAL standard.

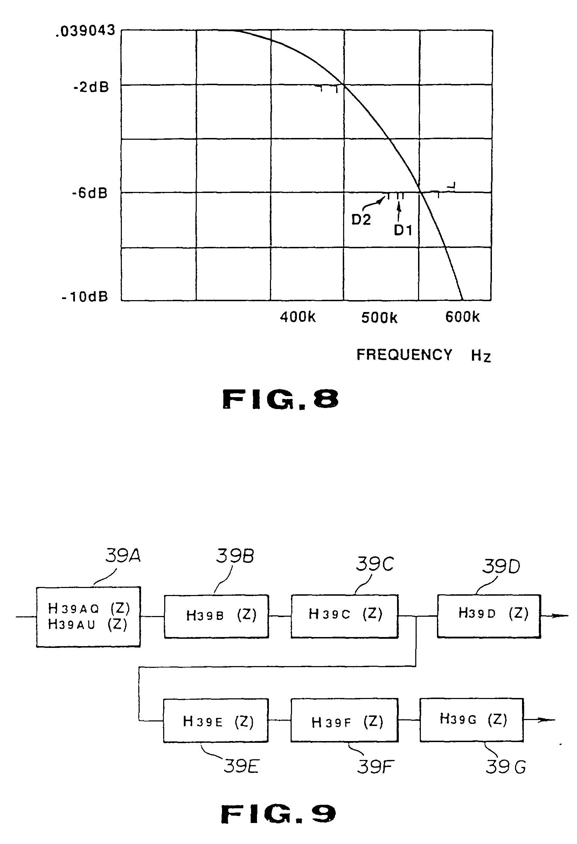

The low-pass filter 39 band-limits the NTSC digital colour difference signal $D_Q$ or the PAL colour difference signal $D_{U^*}$ supplied thereto in accordance with the frequency characteristic graphically illustrated in Figure 8. Thus, the low-pass filter 39 attenuates the NTSC colour difference signal $D_Q$ by less than 2 dB for those components at approximately 0.4 MHz, by less than 6 dB for those components at approximately 0.5 MHz and by more than 6 dB for those components at approximately 0.5 MHz. It will be appreciated that the attenuation characteristics for the PAL colour difference signal $D_{U^*}$ are approximately the same as the attenuation characteristics for the NTSC digital colour difference signal $D_Q$, as represented by Figure 8.

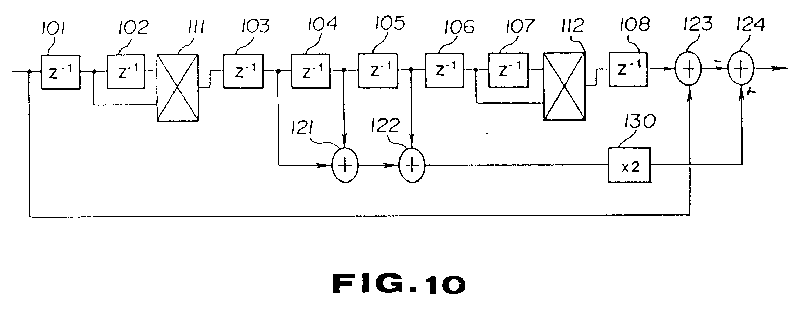

The low-pass filter 39 may be implemented by the cascaded filter elements 39A to 39G as illustrated in Figure 9. In particular, the filter elements 39A, 39B, 39C, 39E, 39F and 39G are used to produce the band-limited NTSC digital colour difference signal $D_Q$; and the cascaded filter elements 39A, 39B, 39C and 39D are used to produce the band-limited PAL colour difference signal $D_{U^*}$. The initial, or input filter element 39A, which is described further below in conjunction with Figure 10, exhibits two different transfer functions: $H_{39AQ}(z)$ when the NTSC digital colour difference signal $D_Q$ is supplied thereto; and $H_{39AU}(z)$ when the PAL colour difference signal $D_{U^*}$ is supplied thereto. Thus, depending upon which of the transfer functions of filter element 39A is selected, the low-pass filter 39 band-limits the colour difference signal supplied thereto in accordance with one or the other of the following transfer functions:

$$H_{39Q}(z) = \frac{1}{2^{11}} (z^{-3}+1)(z^{-1}+1)(3z^{-4}+2z^{-2}+3) (z^{-2}+2z^{-1}+1)$$

$$x(z^{-4}+2z^{-2}+1)(-z^{-8}+2z^{-5}+2z^{-4}+2z^{-3}-1) \tag{6}$$

$$H_{39U}(z) = \frac{1}{2^{8}} (z^{-2}+2z^{-1}+1)^{2}(z^{-4}+2z^{-2}+1)$$

$$x(-z^{-6}+2z^{-4}+2z^{-3}+2z^{-2}-1) \tag{7}$$

Assuming that the selector 38 supplies the NTSC colour difference signal $D_Q$ to the low-pass filter 39, the filter element 39A is operated, as will be discussed below in conjunction with Figure 10, to process the colour difference signal in accordance with the following transfer function:

$$H_{39AQ}(z) = \frac{1}{2^{2}} (-z^{-8}+2z^{-5}+2z^{-4}+2z^{-3}-1) \tag{8}$$

Alternatively, if the selector 38 supplies the PAL colour difference signal $D_{U*}$ to the low-pass filter 39, the filter element 39A processes the colour difference signal in accordance with the following transfer characteristic:

$$H_{39AU}(z) = \frac{1}{2^{2}} (-z^{-6}+2z^{-4}+2z^{-3}+2z^{-2}-1) \tag{9}$$

The colour difference signal processed by the filter element 39A is supplied to the filter element 39B which processes this digital colour difference signal in accordance with the following transfer function:

$$H_{39B}(z) = \frac{1}{2^{2}} (z^{-4}+2z^{-2}+1) \tag{10}$$

The processed digital colour difference signal produced by the filter element 39B is coupled to the filter element 39C which provides further processing of the digital colour difference signal in accordance with the following transfer function:

$$H_{39C}(z) = \frac{1}{2^{2}} (z^{-2}+2z^{-1}+1) \tag{11}$$

The further processed digital colour difference signal produced by the filter element 39C is supplied to the filter element 39D which operates in accordance with the following transfer function:

$$H_{39D}(z) = \frac{1}{2^{2}} (z^{-2}+2z^{-1}+1) \tag{12}$$

As mentioned above, the digital colour difference signal processed by the filter element 39D constitutes the band-limited PAL colour difference signal $D_{U*}$; and this band-limited colour difference signal is provided at the output of the low-pass filter 39 and, as shown in Figure 5, is selectively coupled to the modulator 43 via a burst mixer 46 by a selector 45.

The digital colour difference signal processed by the filter element 39C is also supplied to the filter element 39E as shown in Figure 9. This filter element 39E processes the colour difference signal supplied thereto in accordance with the following transfer function:

$$H_{39E}(z) = \frac{1}{2^{3}} (3z^{-4}+2z^{-2}+3) \tag{13}$$

The further processed digital colour difference signal produced by the filter element 39E is coupled to the filter element 39F which provides further processing thereof in accordance with the following transfer function:

$$H_{39F}(z) = \frac{1}{2} (z^{-1}+1) \tag{14}$$

Finally, the digital colour difference signal processed by the filter element 39F is supplied for further processing by the filter element 39G in accordance with the following transfer function:

$$H_{39G}(z) = \frac{1}{2} (z^{-3}+1) \tag{15}$$

The output of filter element 39G constitutes the band-limited NTSC colour difference signal $D_Q$. This band-limited colour difference signal $D_Q$ is subjected to a clock rate increase by an interpolator 50, as will be described, and thereafter is selectively coupled to the modulator 43 via the burst mixer 46 by way of the selector 45.

One form of the filter element 39A, which can selectively exhibit the transfer function represented by equation (8) or by equation (9), is illustrated in the block diagram of Figure 10. In this block diagram, it will be recognized that each block identified as $z^{-1}$ is a delay circuit to delay the original colour difference signal supplied thereto by one sampling period. It will also be appreciated that the sampling period varies as a function of whether the encoder 8 operates in accordance with the NTSC or PAL standard and, furthermore, whether the encoder 8 produces digital component video signals in the D-1 format or digital composite video signals in the D-2 format. It will be recalled that the sampling frequency $f_s$ which, of course, determines the duration of the sampling period, is selectable in accordance with the following table:

| STANDARD | FORMAT | $f_s$ |
|----------|--------|-------|
| NTSC | D-1 | 13.5 MHz |
| NTSC | D-2 | 14.3 MHz |
| PAL | D-1 | 13.5 MHz |
| PAL | D-2 | 17.7 MHz |
| PAL | --- | 908 $f_H$ |
| PAL | --- | 944 $f_H$ |

Consistent with the foregoing, the delay imparted by each delay circuit is preferably adjustable and selectable as a function of whether the encoder 8 operates in accordance with the NTSC or PAL standard and, furthermore operates to produce digital component or digital composite video signals (that is either in the D-1 or D-2 format). It will be appreciated, therefore, that each delay circuit may be implemented by a simple programmable divider supplied with a reference high frequency clock signal that is frequency-divided by the factor N, where N is selectable to produce the value of the clock frequency $f_s$ set out in the foregoing table.

As shown in Figure 10, the filter element 39A comprises eight delay circuits 101 to 108 connected in cascade. To implement the transfer function represented by equation (8) above, all eight of these delay circuits 101 to 108 are used. However, to implement the transfer function represented by equation (9), the delay circuits 102 and 107 are by-passed. A selector 111 is operated selectively to by-pass the delay circuit 102 and a selector 112 is operated selectively to by-pass the delay circuit 107. It will be appreciated, therefore, that when the low-pass filter 39 is supplied with the NTSC digital colour difference signal $D_Q$, the selector 111 couples the delay circuit 102 to the delay circuit 103 and the selector 112 couples the delay circuit 107 to the delay circuit 108. However, when the low-pass filter 39 is supplied with the PAL colour difference signal $D_{U*}$, the selector 111 by-passes the delay circuit 102 and couples the delay circuit 101 directly to the delay circuit 103; and the selector 112 by-passes the delay circuit 107 and couples the delay circuit 106 directly to the delay circuit 108.

The filter element 39A, as shown in Figure 10, also includes an adder 121 for summing the outputs of the delay circuits 103 and 104, and an adder 122 for summing the output of the delay circuit 105 to the summed outputs provided by the adder 121. It will be appreciated that, alternatively, a single adder may be used to sum the outputs of the delay circuits 103, 104 and 105.

Another adder 123 is coupled to the output of the delay circuit 108 and sums this output with the digital colour difference signal supplied to the input of the filter element 39A. The summed output provided by the adder 123 is subtracted from the summed output of the adder 122, the latter having its value doubled, or multiplied by the coefficient "2", by a coefficient multiplier 130. The implementation shown in Figure 10 thus operates to provide the transfer function represented by equation (8) when the NTSC digital colour difference signal $D_Q$ is supplied to the low-pass filter 39 by the selector 38; and to provide the transfer function represented by equation (9) when the PAL digital colour difference signal $D_{U*}$ is supplied thereto.

It is seen that, by supplying a down sampled digital colour difference signal $D_Q$ to the low-pass filter 39, rather than the digital colour difference signal $D_{Q**}$ having the clock rate $2f_s$, the complexity and, thus, the hardware needed to band-limit the colour difference signal in accordance with the frequency characteristic illustrated in Figure 8 is substantially reduced.

The interpolator 50 is coupled to the low-pass filter 39 to receive the band-limited NTSC digital colour difference signal $D_Q$. For example, the interpolator 50 is coupled to the output of the filter element 39G, shown in Figure 9. The interpolator 50 may be of known construction and operates in a known manner to increase the clock rate of the band-limited colour difference signal $D_Q$ supplied thereto. The resultant band-limited digital colour difference signal exhibits the clock rate $f_s$; and this digital colour difference signal $D_{Q*}$ is coupled to a blanking mixer 51 which is supplied with blanking data from a blanking strobe generator 52, and operates to insert this blanking data into the interpolated, band-limited digital colour difference signal $D_{Q*}$. The selector 45 is coupled directly to the low-pass filter 39 and to the output of the blanking mixer 51, and selects either the band-limited digital colour difference signal $D_{Q*}$ into which blanking data has been inserted, or the band-limited colour difference signal $D_{U*}$, for application to the burst mixer 46. The burst mixer 46 is similar to the burst mixer 42, and is supplied with burst data from the burst strobe generator 44 for insertion into the selectively supplied band-limited NTSC digital colour difference signal $D_{Q*}$ or band-limited PAL digital colour difference signal $D_{U*}$. As shown in Figure 5, the output of the burst mixer 46 is coupled to the modulator 43.

It will be appreciated, therefore, that when the encoder 8 operation in accordance with the NTSC standard, the modulator 43 is supplied with digital colour difference signals $D_{I*}$ and $D_{Q*}$ by the burst mixers 42 and 46, these colour difference signals having been band-limited by the low-pass filters 37 and 39, respectively. However, when the encoder 8 operates in accordance with the PAL standard, the modulator 43 is supplied with band-limited digital colour difference signals $D_{V*}$ and $D_{U*}$ from the low-pass filters 37 and 39, respectively, by way of the burst mixers 42 and 46. The modulator 43 performs a modulating operation in which a colour sub-carrier supplied thereto by a colour sub-carrier generator 53 is subjected to orthogonal biaxial modulation by the colour difference signals $D_{I*}$ and $D_{Q*}$ or the by the colour difference signals $D_{U*}$ and $D_{V*}$. Figure 3D illustrates the signal spectrum of the NTSC digital colour difference signals $D_{I*}$ and $D_{Q*}$; and Figure 4D illustrates the signal spectrum of the PAL colour difference signals $D_{V*}$ and $D_{U*}$. The modulator 43 produces modulated colour difference signals MOD.C* at the $f_s$ clock rate, and these modulated colour difference signals in the NTSC standard exhibit a frequency distribution containing odd harmonics of the colour sub-carrier frequency $f_{sc}$ as shown in Figure 3E. The modulated colour difference signals MOD.C in the PAL standard exhibit the frequency distribution shown in Figure 4E containing difference frequency components $f_s - f_{sc}$ and $2f_s - f_{sc}$, and sum frequency components $f_s + f_{sc}$.

The modulated colour difference signals MOD.C* contain the $3f_{sc}$ frequency component (Figure 3E) or the $f_s - f_{sc}$ frequency component (Figure 4E) which will adversely affect the composite video signals when the encoder 8 operates in accordance with the D-2 format. To avoid this, a rate converter 54 is coupled to the modulator 43 to process the modulated colour difference signal MOD.C* by digital filtering with the filtering characteristics shown in Figures 3F and 4F, to extract the frequency components $f_{sc}$ and $7f_{sc}$ when NTSC colour difference signals are supplied thereto; and to extract the frequency components $f_{sc}$ and $2f_s - f_{sc}$ when PAL colour difference signals are supplied thereto.

The resultant operation performed on the modulated colour difference signals MOD.C* by the rate converter 54 results in modulated colour difference signals MOD.C** as shown in Figures 3G or 4G, depending again on whether NTSC or PAL colour difference signals are supplied to the modulator 43. The filter characteristics exhibited by the digital filter included in the rate converter 54 pass the colour sub-carrier frequency component $f_{sc}$ and block the frequency components $3f_{sc}$ and $f_s - f_{sc}$.

A further selector 55 is coupled directly to the output of the. modulator 43 and also to the output of the rate converter 54 and supplies to an output terminal 56 the modulated colour difference signal MOD.C** in either the NTSC or PAL standard. The output of the selector 55 is also coupled to the Y/C mixer 22 for combining the modulated colour difference signals MOD.C** with the digital luminance signal $D_{Y**}$. It is appreciated, therefore, that the delay circuit 21, through which the digital luminance signal $D_{Y**}$ is supplied to the Y/C mixer 22, compensated (or matches) the inherent time delays exhibited by the colour difference section of the encoder 8 shown in Figure 5. As a result, the Y/C mixer 22 produces a digital composite video signal $D_{CS**}$ at the $2_{fs}$ clock rate; and this digital composite video signal is coupled to the output terminal 57 for use in recording, transmission or other processing in the D-2 format.

From the foregoing, it is seen that a common encoder is provided to encode digital colour television signals in either the NTSC or PAL standard to produce digital component or digital composite video signals in either the D-1 or D-2 format. Band-limiting of NTSC and PAL colour difference signals is attained by a common low-pass filter; and by reducing the clock rate of the digital colour difference signals supplied to the low-pass filter, as by down sampling the NTSC Q signal, the complexity and requisite hardware to implement the band-limiting processing is significantly reduced.

Additionally, relatively simple level setting, or gain adjusting, circuits are provided to assign desired quantizing values to particular reference levels of the digital component or digital composite video signals (that is reference levels in the D-1 or D-2 format), whether the video signals are consistent with NTSC or PAL (or any other) television standard.

## Claims

1. Digital colour television camera apparatus for selectively producing either a digital component video signal or a digital composite video signal, the apparatus comprising:

    image means (1, 2, 3, 4) for providing digital primary colour image signals;
    encoding means (8) coupled to receive said digital primary colour image signals and operable in a first mode to encode said digital primary colour image signals to produce a digital component video signal, and in a second mode to encode said digital primary colour image signals to produce a digital composite video signal; and
    level setting means (13) included in said encoding means (8) and operable when said encoding means (8) operates in said first mode for establishing predetermined quantizing values to represent respective reference levels of said digital component video signal, said level setting means (13) being operable when said encoding means operates in said second mode for establishing different predetermined quantizing values to represent

EP 0 507 450 B1

respective reference levels of said digital composite video signals.

2. Apparatus according to claim 1, wherein said digital component video signal includes luminance and colour difference components, and said respective reference levels correspond to 0% and 100% of the luminance component and to 0% and ± 100% of the colour difference components.

3. Apparatus according to claim 1, wherein said digital composite video signals includes luminance and synchronizing signals, and said respective reference levels correspond to 0% and 100% of the luminance signal and to a sync tip level of the synchronizing signal.

4. Apparatus according to claim 1 wherein said level setting means (13) establishes 8-bit quantizing values to represent samples of the digital component video signal.

5. Apparatus according to claim 1 wherein said level setting means (13) establishes 10-bit quantizing values to represent samples of the digital composite video signal.

6. Apparatus according to claim 1 wherein the digital component and digital composite video signals produced by said encoding means (8) represent NTSC video signals.

7. Apparatus according to claim 1 wherein the digital component and digital composite video signals produced by said encoding means (8) represent PAL video signals.

8. Apparatus according to claim 1 wherein said encoding means (8) operates in accordance with a first television standard selectively to encode NTSC video signals as digital component or digital composite video signals, and in accordance with a second television standard selectively to encode PAL video signals as digital component or digital composite video signals; and wherein the quantized values which represent reference levels of NTSC digital composite video signals differ from the quantized values which represent reference levels of PAL digital composite video signals.

9. Apparatus according to claim 8 wherein the quantized values which represent reference levels of NTSC digital component video signals are substantially equal to the quantized values which represent reference levels of PAL digital component video signals.

10. Digital colour television camera apparatus for selectively producing either a digital component video signal or a digital composite video signal in accordance with either a first or a second television standard, the apparatus comprising:

image means (1, 2, 3, 4) for providing digital primary colour image signals at a predetermined sampling clock rate $2f_s$ from which said digital component or digital composite video signal is derived;
matrix means (47, 25, 31) coupled to receive said digital primary colour image signals at said sampling clock rate for producing colour difference signals therefrom at said sampling clock rate;
down sampling means (49, 30) coupled to said matrix means (47, 25, 31) for down sampling at least one of the colour difference signals to reduce the sampling clock rate thereof; and
digital low-pass filtering means (37, 39) operable in accordance with said first television standard to limit the frequency band of the down-sampled colour difference signal by providing predetermined selected attenuation at pre-established frequencies of the down-sampled colour difference signal, said digital low-pass filtering means (37, 39) being operable in accordance with said second television standard to limit the frequency band of the down-sampled colour difference signal by providing predetermined selected attenuation at different pre-frequencies of the down-sampled difference signal, thereby producing a band-limited colour difference signal for said digital composite video signal.

11. Apparatus according to claim 10 further comprising interpolating means (50) coupled to said digital low-pass filtering means (37, 39) for increasing the clock rate of at least the band-limited, down-sampled colour difference signal when said digital low-pass filtering means (37, 39) operates in accordance with said first television standard.

12. Apparatus according to claim 11 further comprising modulating means (43) for modulating a sub-carrier with the increased clock rate colour difference signal produced by said interpolating means (50) when said digital low-pass filtering means (37, 39) operates in accordance with said first television standard, and for modulating a sub-carrier

13

with the band-limited down-sampled colour difference signal produced by said digital low-pass filtering means (37, 39) when said low-pass filtering means (37, 39) operates in accordance with said second television standard, the modulated sub-carrier being included in said digital composite video signal.

13. Apparatus according to claim 12 wherein said matrix means (47, 25, 31) comprises a first matrix (47) for producing a digital colour difference signal $D_Q$ in accordance with said first television standard; and wherein said down-sampling means (49, 30) comprises a first down sampler (49) for down sampling said colour difference signal $D_Q$ to reduce the sampling clock rate thereof to $f_s/2$.

14. Apparatus according to claim 13 wherein said interpolating means (50) increases the clock rate of the band-limited digital colour difference signal $D_Q$ produced in accordance with said first television standard to a clock rate $f_s$.

15. Apparatus according to claim 13 wherein said matrix means (47, 25, 31) further comprises second and third matrices (25, 31) for respectively producing digital red and blue colour difference components from said digital primary colour image signals and for producing a digital colour difference signal $D_U$ from said digital red and blue colour difference components in accordance with said second television standard; and wherein said down sampling means (49, 30) further comprises a second down sampler (30) for down sampling said digital red and blue colour difference components to a block rate $f_s$ and supplying the down-sampled digital red and blue colour difference components to said third matrix (31).

16. Apparatus according to claim 15 further comprising selector means (38) for selectively coupling to said low-pass filter means (37, 39) the down-sampled digital colour difference signal $D_Q$ when said low-pass filter means (37, 39) operates in accordance with said first television standard or the down-sampled digital colour difference signal $D_U$ when said low-pass filter means (37, 39) operates in accordance with said second television standard.

17. Apparatus according to claim 15 wherein said third matrix (31) is operable to produce additional colour difference signals $D_I$ from said digital red and blue colour difference components in accordance with said first television standard and additional colour difference signals $D_V$ from said digital red and blue colour difference components in accordance with said second television standard; and further comprising second digital low-pass filtering means (37) coupled to said third matrix (31) to limit the frequency band of the additional colour difference signals $D_I$ and $D_V$ produced by said third matrix (31) by providing a predetermined first attenuation at a first frequency of the additional colour difference signal $D_I$ and a predetermined second attenuation at a second frequency of the additional colour difference signal $D_V$, the band-limited additional colour difference signal $D_I$ and $D_V$ being coupled to said modulating means (43).

18. Apparatus according to claim 17 further comprising additional selector means (41) for selectively coupling to said modulating means (43) the additional colour difference signal $D_I$ when the first-mentioned digital low-pass filtering means (37) operates in accordance with said first television standard and the additional colour difference signal $D_V$ when said first-mentioned digital low-pass filtering means (37) operates in accordance with said second television standard.

19. Apparatus according to claim 15, further comprising level setting means (28) coupled to receive the digital red and blue colour difference components for establishing predetermined quantizing values to represent respective reference levels of the digital red and blue colour difference components for said digital component or digital composite video signals produced in accordance with said first or said second television standard.

20. Apparatus according to claim 19 further comprising combining means (11) for combining said digital primary colour image signals to produce a digital luminance for said digital component and digital composite video signals.

21. A common encoder (8) for a colour television camera operable in accordance with first or second television standards to selectively encode digital primary colour image signals at a sampling clock rate into digital component or digital composite video signals, said encoder comprising:

luminance signal generating means (11) for combining the digital primary colour image signals to generate a luminance signals therefrom;
level setting means (13) for establishing predetermined quantizing values for said luminance signal to represent respective reference levels of the digital component and digital composite video signals when the colour television camera operates in accordance with said first or second television standard;

matrix means (25) for combining the luminance signals and at least predetermined ones of said digital primary colour image signals to produce colour difference components at said sampling clock rate;

first colour difference signal means (31) coupled to receive and selectively produce from the colour difference components first digital colour difference signals in accordance with said first or second television standard;

first down sampling means (30) for providing the first digital colour difference signals with a clock rate reduced from said sampling clock rate;

first low-pass filter means (37) for frequency band limiting selected ones of the reduced clock rate first colour difference signals in said first and second television standards;

second colour difference signal means (47) for combining the digital primary colour image signals to generate a predetermined digital colour difference signal in accordance with said first television standard;

second down sampling means (49) for down sampling the predetermined digital colour difference signal to a clock rate less than said sampling clock rate;

second low-pass filter means (39) for frequency band limiting either the down-sampled predetermined digital colour difference signal or one of the digital colour difference signals of reduced clock rate produced in accordance with said second television standard; and modulating means (43) for modulating a sub-carrier with the band limited colour difference signals provided by said first and second low-pass filter means (37, 39) for use in said digital composite video signal.

22. An encoder according to claim 21 further comprising second level setting means (28) for establishing quantizing levels of said colour difference components produced by said matrix means (25).

23. An encoder according to claim 22 wherein the predetermined quantizing values for said luminance signal represent 0% and 100% and wherein the quantizing levels of said colour difference components represent 0%, +100% and -100%.

24. An encoder according to claim 23 wherein the predetermined quantizing values for said luminance signal further represent a sync tip level.

25. An encoder according to claim 21 wherein said colour difference components and said luminance signal comprise the digital component video signal.

26. An encoder according to claim 25 wherein said first colour difference signal means (31) comprises second matrix means (31) and said first down sampling means (30) is connected to the first-mentioned matrix means (25) for supplying down-sampled colour difference components to said second matrix means (31).

27. An encoder according to claim 26 wherein said second matrix means (31) produces digital I colour difference signals in accordance with said first television standard and digital U and V colour difference signals in accordance with said second television standard; and wherein said first low-pass filter means (37) is connected to receive said digital I or said digital V colour difference signals when the colour television camera operates in accordance with said first or second television standard, respectively.

28. An encoder according to claim 27 wherein said second colour difference signal means (47) comprises third matrix means (47) for producing digital Q colour difference signals; and wherein said second low-pass filter means (39) is connected to receive said digital Q or said digital U colour difference signals when said colour television camera operates in accordance with said first or second television standard, respectively.

29. An encoder according to claim 28 wherein said second down sampling means (49) down samples the clock rate of said digital Q colour difference signal from $2f_s$ to $f_s/2$.

**Patentansprüche**

1. Gerät für eine Farbfernsehkamera zur selektiven Erzeugung entweder eines digitalen Komponenten-Videosignals oder eines digitalen Videosignalgemischs, wobei das Gerät aufweist:

    eine Abbildungseinrichtung (1, 2, 3, 4) zur Lieferung von digitalen Primärfarbbildsignalen,
    eine Kodiereinrichtung (8), die die so angeordnet ist, daß sie die digitalen Primärfarbbildsignale aufnimmt, und die in einem ersten Modus betrieben werden kann, in dem sie die digitalen Primärfarbbildsignale für die Erzeugung eines digitalen Komponenten-Videosignals kodiert, und einem zweiten Modus, in dem sie die digitalen Primärfarbbildsignale für die Erzeugung eines digitalen Videosignalgemischs kodiert,

eine in der Kodiereinrichtung (8) enthaltene Pegeleinstelleinrichtung (13), die dann, wenn die Kodiereinrichtung (8) in dem genannten ersten Modus arbeitet, so betrieben werden kann, daß sie vorbestimmte Quantisierungswerte zur Darstellung der jeweiligen Referenzpegel des digitalen Komponenten-Videosignals einrichtet, und dann, wenn die Kodiereinrichtung (8) in dem zweiten Modus arbeitet, so betrieben werden kann, daß sie abweichende vorbestimmte Quantisierungswerte zur Darstellung der jeweiligen Referenzpegel der jeweiligen Referenzpegel des digitalen Videosignalgemischs einrichtet.

2. Gerät nach Anspruch 1,

bei dem das digitale Komponenten-Videosignal Luminanz- und Farbdifferenzkomponenten enthält und die jeweiligen Referenzpegel 0% bis 100% der Luminanzkomponente und 0% bis 100% der Farbdifferenzkomponenten entsprechen.

3. Gerät nach Anspruch 1,

bei dem das digitale Videosignalgemisch Luminanz- und Synchronisiersignale enthält und die jeweiligen Referenzpegel 0% bis 100% der Luminanzkomponente und dem Synchronisierspitzenpegel des Synchronisiersignals entsprechen.

4. Gerät nach Anspruch 1,

bei dem die Pegeleinstelleinrichtung (13) 8-Bit-Quantisierungswerte zur Darstellung von Abtastproben des digitalen Komponenten-Videosignals einrichtet.

5. Gerät nach Anspruch 1,

bei dem die Pegeleinstelleinrichtung (13) 10-Bit-Quantisierungswerte zur Darstellung von Abtastproben des digitalen Videosignalgemischs einrichtet.

6. Gerät nach Anspruch 1,

bei dem das digitale Komponenten-Videosignal und das digitale Videosignalgemisch, die von der Kodiereinrichtung (8) erzeugt werden, NTSC-Videosignale darstellen.

7. Gerät nach Anspruch 1,

bei dem das digitalen Komponenten-Videosignal und das digitale Videosignalgemisch, die von der Kodiereinrichtung (8) erzeugt werden, PAL-Videosignale darstellen.

8. Gerät nach Anspruch 1,

bei dem die Kodiereinrichtung (8) nach einer ersten Fernsehnorm arbeitet, wobei selektiv NTSC-Videosignale als digitales Komponenten-Videosignal oder als digitales Videosignalgemisch kodiert werden, oder nach einer zweiten Fernsehnorm, wobei selektiv PAL-Videosignale als digitales Komponenten-Videosignal oder als digitales Videosignalgemisch kodiert werden, und bei dem die quantisierten Werte, welche Referenzpegel des digitalen NTSC-Videosignalgemischs darstellen, von den quantisierten Werten abweichen, die Referenzpegel des digitalen NTSC-Videosignalgemischs darstellen.

9. Gerät nach Anspruch 8,

bei dem die quantisierten Werte, die Referenzpegel von digitalen NTSC-Komponenten-Videosignalen darstellen, im wesentlichen die gleichen sind wie diejenigen, die die quantisierten Werte von Referenzpegeln von digitalen PAL-Komponenten-Videosignalen darstellen.

10. Gerät für eine Farbfernsehkamera zur selektiven Erzeugung entweder eines digitalen Komponenten-Videosignals oder eines digitalen Videosignalgemischs nach einer ersten oder einer zweiten Fernsehnorm, wobei das Gerät aufweist:

eine Abbildungseinrichtung (1, 2, 3, 4) zur Lieferung von digitalen Primärfarbbildsignalen mit einer vorbestimmten Abtasttaktrate $2f_S$, aus denen das digitale Komponenten-Videosignal oder das digitale Videosignalgemisch abgeleitet wird,

eine Matrixeinrichtung (47, 25, 31), die so angeordnet ist, daß sie die digitalen Primärfarbbildsignale mit der genannten Abtasttaktrate aufnimmt, um daraus Farbdifferenzsignale mit der genannten Abtasttaktrate zu erzeugen,

eine mit der Matrixeinrichtung (47, 25, 31) verbundene Abwärtsabtasteinrichtung (49, 30) zum Abwärtsabtasten wenigstens eines der Farbdifferenzsignale, um dessen Abtasttaktrate zu verringern,

eine digitale Tiefpaßfiltereinrichtung (37, 39), die nach der ersten Fernsehnorm betreibbar ist, um das Frequenzband des abwärtsabgetasteten Farbdifferenzsignals durch Anwendung einer vorbestimmten ausgewählten Dämpfung bei vorgewählten Frequenzen des abwärtsabgetasteten Farbdifferenzsignals zu begrenzen, wobei die digitale Tiefpaßfiltereinrichtung (37, 39) ferner nach der zweiten Fernsehnorm betreibbar ist, um das Frequenzband des abwärtsabgetasteten Farbdifferenzsignals durch Anwendung einer vorbestimmten ausgewählten Dämpfung bei anderen vorgewählten Frequenzen des abwärtsabgetasteten Farbdifferenzsignals zu begrenzen und dadurch ein bandbegrenztes Farbdifferenzsignal für das Videosignalgemisch zu erzeugen.

11. Gerät nach Anspruch 10

mit einer mit der Tiefpaßfiltereinrichtung (37, 39) verbundenen Interpoliereinrichtung (50) zur Erhöhung der Abtasttaktrate zumindest des bandbegrenzten abwärtsabgetasteten Farbdifferenzsignals, wenn die digitale Tiefpaßfiltereinrichtung (37, 39) nach der ersten Fernsehnorm arbeitet.

12. Gerät nach Anspruch 11 mit einer Modulatoreinrichtung (43)

zum Modulieren eines Hilfsträgers mit dem von der Interpoliereinrichtung (50) erzeugten Farbdifferenzsignal mit erhöhter Abtasttaktrate, wenn die digitale Tiefpaßfiltereinrichtung (37, 39) nach der ersten Fernsehnorm arbeitet,

und zum Modulieren eines Hilfsträgers mit dem von der digitalen Tiefpaßfiltereinrichtung (37, 39) erzeugten bandbegrenzten abwärtsabgetasteten Farbdifferenzsignals, wenn die Tiefpaßfiltereinrichtung (37, 39) nach der zweiten Fernsehnorm arbeitet,

wobei der modulierte Hilfsträger in dem digitalen Videosignalgemisch enthalten ist.

13. Gerät nach Anspruch 12,

bei dem die Matrixeinrichtung (47, 25, 31) eine erste Matrix (47) zur Erzeugung eines digitalen Farbdifferenzsignals $D_Q$ nach der ersten Fernsehnorm aufweist,

und bei der die Abwärtsabtasteinrichtung (49, 30) einen ersten Abwärtsabtaster (49) zum Abwärtsabtasten dieses Farbdifferenzsignals $D_Q$ aufweist, um dessen Abtasttaktrate auf $f_S/2$ zu reduzieren.

14. Gerät nach Anspruch 13,

bei dem die Interpoliereinrichtung (50) die Abtasttaktrate des nach der ersten Fernsehnorm erzeugten bandbegrenzten digitalen Farbdifferenzsignals $D_Q$ auf die Taktrate $f_S$ erhöht.

15. Gerät nach Anspruch 13,

bei dem die Matrixeinrichtung (47, 25, 31) eine zweite und eine dritte Matrix (25, 31) besitzt zur Erzeugung digitaler Rot- bzw. Blau-Farbdifferenzkomponenten aus den digitalen Primärfarbbildsignalen und zur Erzeugung eines digitalen Farbdifferenzsignals $D_U$ aus den Rot- und Blau-Farbdifferenzkomponenten nach der zweiten Fernsehnorm,

und bei dem die Abwärtsabtasteinrichtung (49, 30) außerdem einen zweiten Abwärtsabtaster (30) besitzt zum Abwärtsabtasten der Rot- und Blau-Farbdifferenzkomponenten auf eine Blockrate $f_S$ und zur Lieferung der abwärtsabgetasteten Rot- und Blau-Farbdifferenzkomponenten an die dritte Matrix (31).

16. Gerät nach Anspruch 15

mit einer Auswahleinrichtung (38), die wahlweise entweder das abwärtsabgetastete Farbdifferenzsignal $D_Q$ an die Tiefpaßfiltereinrichtung (37, 39) weitergibt, wenn diese nach der ersten Fernsehnorm arbeitet, oder das abwärtsabgetastete Farbdifferenzsignal $D_U$, wenn die Tiefpaßfiltereinrichtung (37, 39) nach der zweiten Fernsehnorm arbeitet.

17. Gerät nach Anspruch 15,

bei dem die dritte Matrix (31) so betrieben werden kann, daß sie zusätzliche Farbdifferenzsignale $D_I$ aus den digitalen Rot- und Blau-Farbdifferenzkomponenten nach der ersten Fernsehnorm und zusätzliche Farbdifferenzsignale $D_V$ aus den digitalen Rot- und Blau-Farbdifferenzkomponenten nach der zweiten Fernsehnorm erzeugt,

und bei dem eine mit der dritten Matrix (31) verbundene zweite digitale Tiefpaßfiltereinrichtung (37) vorgesehen ist, die eine Frequenzbandbegrenzung der von der dritten Matrix (31) erzeugten zusätzlichen Farbdifferenzsignale $D_I$ und $D_V$ bewirkt, indem sie eine vorbestimmte erste Dämpfung bei einer ersten Frequenz des zusätzlichen Farbdifferenzsignals $D_I$ und eine vorbestimmte zweite Dämpfung bei einer zweiten Frequenz des zusätzlichen Farbdifferenzsignals $D_V$ verursacht, wobei die bandbegrenzten zusätzlichen Farbdifferenzsignale $D_I$ und $D_V$ der Modulatoreinrichtung (43) zugeführt werden.

18. Gerät nach Anspruch 17

mit einer weiteren Auswahleinrichtung (41), die wahlweise das zusätzliche Farbdifferenzsignal $D_I$ an die Modulatoreinrichtung (43) weitergibt, wenn die erstgenannte Tiefpaßfiltereinrichtung (37) nach der ersten Fernsehnorm arbeitet, oder das zusätzliche Farbdifferenzsignal $D_V$, wenn die erstgenannte Tiefpaßfiltereinrichtung (37) nach der zweiten Fernsehnorm arbeitet.

19. Gerät nach Anspruch 15

mit einer Pegeleinstelleinrichtung (28), die die digitalen Rot- und Blau-Farbdifferenzkomponenten aufnimmt, um vorbestimmte Quantisierungswerte zur Darstellung der jeweiligen Referenzpegel der digitalen Rot- und Blau-Farbdifferenzkomponenten für die nach der ersten oder der zweiten Fernsehnorm erzeugten digitalen Komponenten-Videosignale oder digitalen Videosignalgemische einzurichten.

20. Gerät nach Anspruch 19

mit einer Kombiniereinrichtung (11) zum Kombinieren der digitalen Primärfarbbildsignale, um ein digitales Luminanzsignal für die digitalen Komponenten-Videosignale oder digitalen Videosignalgemische erzeugen.

21. Gemeinsamer Kodierer (8) für eine Farbfernsehkamera, der nach einer ersten oder einer zweiten Fernsehnorm betrieben werden kann, um wahlweise digitale Primärfarbbildsignale mit einer Abtasttaktrate in digitale Komponenten-Videosignale oder ein digitales Videosignalgemisch zu kodieren, wobei der Kodierer (8) aufweist:

eine Luminanzsignalgeneratoreinrichtung (11) zum Kombinieren der Primärfarbbildsignale, um daraus ein Luminanzsignal zu erzeugen,
eine Pegeleinstelleinrichtung (13) zum Einrichten vorbestimmter Quantisierungswerte für das Luminanzsignal zur Darstellung der jeweiligen Referenzpegel des digitalen Komponenten-Videosignals und des digitalen Videosignalgemischs, wenn die Farbfernsehkamera nach der ersten oder der zweiten Fernsehnorm arbeitet,
eine Matrixeinrichtung (25) zum Kombinieren der Luminanzsignale und zumindest bestimmter Exemplare der digitalen Primärfarbbildsignale, um Farbdifferenzsignale mit der genannten Abtasttaktrate zu erzeugen;
eine erste Farbdifferenzsignaleinrichtung (31), die so angeordnet ist, daß sie nach Maßgabe der ersten oder der zweiten Fernsehnorm erste digitale Farbdifferenzsignale aus den Farbdifferenzkomponenten empfängt und erzeugt,
eine erste Abwärtsabtasteinrichtung (30) zur Bereitstellung der ersten digitalen Farbdifferenzsignale mit einer aus der genannten Abtasttaktrate abgeleiteten reduzierten Taktrate,
eine erste Tiefpaßfiltereinrichtung (37) zur Frequenzbandbegrenzung ausgewählter Exemplare der ersten Farbdifferenzsignale mit reduzierter Taktrate in der ersten und zweiten Fernsehnorm,
eine zweite Farbdifferenzsignaleinrichtung (47) zum Kombinieren der digitalen Primärfarbbildsignal zur Erzeugung eines vorbestimmten digitalen Farbdifferenzsignals nach der ersten Fernsehnorm,
eine zweite Abwärtsabtasteinrichtung (49) zum Abwärtsabtasten des vorbestimmten digitalen Farbdifferenzsignals auf eine Taktrate, die kleiner ist als die genannte Abtasttaktrate,
eine zweite Tiefpaßfiltereinrichtung (39) zur Frequenzbandbegrenzung entweder des abwärtsabgetasteten vorbestimmten digitalen Farbdifferenzsignals oder eines der digitalen Farbdifferenzsignale mit reduzierter Taktrate, die nach der zweiten Fernsehnorm erzeugt sind,
und eine Modulatoreinrichtung (43) zum Modulieren eines Hilfsträgers mit den von der ersten an der zweiten Tiefpaßfiltereinrichtung (37, 39) gelieferten bandbegrenzten Farbdifferenzsignalen für die Verwendung in dem digitalen Videosignalgemisch.

22. Kodierer nach Anspruch 21

mit einer zweiten Pegeleinstelleinrichtung (28) zum Einrichten von Quantisierungspegeln der von der Matrixeinrichtung (25) erzeugten Farbdifferenzkomponente.

**23.** Kodierer nach Anspruch 22,

bei dem die vorbestimmten Quantisierungswerte für das Luminanzsignal 0% und 100% und die Quantisierungspegel für die Farbdifferenzkomponenten 0%, +100% und -100% repräsentieren.

**24.** Kodierer nach Anspruch 23,

bei dem die vorbestimmten Quantisierungswerte für das Luminanzsignal ferner einen Synchronspitzenpegel repräsentieren.

**25.** Kodierer nach Anspruch 21,

bei dem die Farbdifferenzkomponenten und das Luminanzsignal das digitale Komponenten-Videosignal umfassen.

**26.** Kodierer nach Anspruch 25,

bei dem die erste Farbdifferenzsignaleinrichtung (31) eine zweite Matrixeinrichtung (31) aufweist, und bei dem die erste Abwärtsabtasteinrichtung (30) mit der erstgenannten Matrixeinrichtung (25) verbunden ist, um der zweiten Matrixeinrichtung (31) abwärtsabgetastete Farbdifferenzkomponenten zuzuführen.

**27.** Kodierer nach Anspruch 26,

bei dem die zweite Matrixeinrichtung (31) digitale I-Farbdifferenzsignale nach der ersten Fernsehnorm und digitale U- und V-Farbdifferenzsignale nach der zweiten Fernsehnorm erzeugt, und bei dem die erste Tiefpaßfiltereinrichtung (37) so angeordnet ist, daß sie das digitale I-Farbdifferenzsignal oder das V-Farbdifferenzsignal aufnimmt, wenn die Farbfernsehkamera nach der ersten bzw. der zweiten Fernsehnorm arbeitet.

**28.** Kodierer nach Anspruch 27,

bei dem die zweite Farbdifferenzsignaleinrichtung (47) eine dritte Matrixeinrichtung (47) zur Erzeugung digitaler Q-Farbdifferenzsignale umfaßt, und bei dem die zweite Tiefpaßfiltereinrichtung (39) so angeordnet ist, daß sie das digitale Q-Farbdifferenzsignal oder das U-Farbdifferenzsignal aufnimmt, wenn die Farbfernsehkamera nach der ersten bzw. der zweiten Fernsehnorm arbeitet.

**29.** Kodierer nach Anspruch 28, bei dem die zweite Abwärtsabtasteinrichtung (49) die Taktrate des digitalen Q-Farbdifferenzsignals von $2f_S$ auf $f_S/2$ heruntertastet.

## Revendications

**1.** Appareil de caméra de télévision en couleur numérique pour produire sélectivement soit un signal vidéo numérique à composantes séparées soit un signal vidéo numérique composite, l'appareil comprenant :

un dispositif d'image (1, 2, 3, 4) pour fournir des signaux numériques d'image de couleur primaire; un dispositif de codage (8) couplé pour recevoir lesdits signaux numériques d'image de couleur primaire et utilisable dans un premier mode pour coder lesdits signaux numériques d'image de couleur primaire pour produire un signal vidéo numérique à composantes séparées, et dans un second mode pour coder lesdits signaux d'image de couleur primaire pour produire un signal vidéo numérique composite ; et un dispositif de réglage de niveau (13) compris dans ledit dispositif de codage (8) et utilisable lorsque ledit dispositif de codage (8) fonctionne dans ledit premier mode pour établir des valeurs de quantification prédéterminées pour représenter des niveaux de référence respectifs dudit signal vidéo numérique à composantes séparées, ledit dispositif de réglage de niveau (13) étant utilisable lorsque ledit dispositif de codage fonctionne dans ledit second mode pour établir différentes valeurs de quantification prédéterminées pour représenter des niveaux de référence respectifs desdits signaux vidéo numériques composites.

**2.** Appareil selon la revendication 1, dans lequel ledit signal vidéo numérique à composantes séparées comprend des composantes de différence de luminance et de chrominance, et lesdits niveaux de référence respectifs correspondent à 0% et 100% de la composante de luminance et à 0% et $\pm$ 100% des composantes de différence de

EP 0 507 450 B1

chrominance.

3. Appareil selon la revendication 1, dans lequel lesdits signaux vidéo numériques composites comprennent des signaux de luminance et de synchronisation, et lesdits niveaux de référence respectifs correspondent à 0% et 100% du signal de luminance et à un niveau de pointe de synchronisation du signal de synchronisation.

4. Appareil selon la revendication 1 dans lequel ledit dispositif de réglage de niveau (13) établit des valeurs de quantification de 8 bits pour représenter des échantillons du signal vidéo numérique à composantes séparées.

5. Appareil selon la revendication 1 dans lequel ledit dispositif de réglage de niveau (13) établit des valeurs de quantification de 10 bits pour représenter des échantillons du signal vidéo numérique composite.

6. Appareil selon la revendication 1 dans lequel les signaux vidéo numériques à composantes séparées et numériques composites produits par ledit dispositif de codage (8) représentent des signaux vidéo NTSC.

7. Appareil selon la revendication 1 dans lequel les signaux vidéo numériques à composantes séparées et numériques composites produits par ledit dispositif de codage (8) représentent des signaux vidéo PAL.

8. Appareil selon la revendication 1 dans lequel ledit dispositif de codage (8) fonctionne selon une première norme de télévision pour coder sélectivement des signaux vidéo NTSC comme des signaux vidéo numériques à composantes séparées ou numériques composites, et selon une seconde norme de télévision pour coder sélectivement des signaux vidéo PAL comme des signaux vidéo numériques à composantes séparées ou numériques composites ; et dans lequel les valeurs de quantification qui représentent des niveaux de référence des signaux vidéo numériques composites NTSC diffèrent des valeurs quantifiées qui représentent des niveaux de référence des signaux vidéo PAL numériques composites.

9. Appareil selon la revendication 8 dans lequel les valeurs quantifiées qui représentent des niveaux de référence des signaux vidéo numériques NTSC à composantes séparées sont substantiellement égales aux valeurs quantifiées qui représentent des niveaux de référence des signaux vidéo numériques PAL à composantes séparées.

10. Appareil de caméra de télévision en couleur numérique pour produire sélectivement soit un signal vidéo numérique à composantes séparées soit un signal vidéo numérique composite selon soit une première soit une seconde norme de télévision, l'appareil comprenant :

un dispositif d'image (1, 2, 3, 4) pour fournir des signaux numériques d'image de couleur primaire à une fréquence d'horloge d'échantillonnage prédéterminée $2f_S$ à partir de laquelle ledit signal vidéo numérique à composantes séparées ou numérique composite est dérivé ;
un dispositif de matrice (47, 25, 31) couplé pour recevoir lesdits signaux numériques d'image de chrominance primaire à ladite fréquence d'horloge d'échantillonnage pour produire des signaux de différence de chrominance à partir de ceux-ci à ladite fréquence d'horloge d'échantillonnage ;
un dispositif de sous-échantillonnage (49, 30) couplé audit dispositif de matrice (47, 25, 31) pour sous-échantillonner au moins un des signaux de différence de chrominance pour réduire la fréquence d'horloge d'échantillonnage de celui-ci ; et
un dispositif de filtre passe-bas numérique (37, 39) utilisable selon ladite première norme de télévision pour réduire la bande de fréquence du signal de différence de chrominance sous-échantillonné en fournissant une atténuation sélectionnée prédéterminée à des fréquences préétablies du signal de différence de chrominance sous-échantillonné, ledit dispositif de filtre passe-bas numérique (37, 39) étant utilisable selon ladite seconde norme de télévision pour réduire la bande de fréquence du signal de différence de chrominance sous-échantillonné en fournissant une atténuation sélectionnée prédéterminée à différentes fréquences préétablies du signal de différence sous-échantillonné, produisant ainsi un signal de différence de chrominance à bande réduite pour ledit signal vidéo numérique composite.

11. Appareil selon la revendication 10 comprenant en outre un dispositif d'interpolation (50) couplé audit dispositif de filtre passe-bas numérique (37, 39) pour augmenter la fréquence d'horloge d'au moins du signal de différence de chrominance sous-échantillonné à bande réduite lorsque ledit dispositif de filtre passe-bas numérique (37, 39) fonctionne selon ladite première norme de télévision.

12. Appareil selon la revendication 11 comprenant en outre un dispositif de modulation (43) pour moduler une sous-porteuse avec le signal de différence de chrominance de fréquence d'horloge augmentée produit par ledit dispositif d'interpolation (50) lorsque ledit dispositif de filtre passe-bas numérique (37, 39) fonctionne selon ladite première norme de télévision, et pour moduler une sous-porteuse avec le signal de différence de chrominance sous-échantillonné à bande réduite produit par ledit dispositif de filtre passe-bas numérique (37, 39) lorsque ledit dispositif de filtre passe-bas (37, 39) fonctionne selon ladite seconde norme de télévision, ladite sous-porteuse modulée étant comprise dans ledit signal vidéo numérique composite.

13. Appareil selon la revendication 12 dans lequel ledit dispositif de matrice (47, 25, 31) comprend une première matrice (47) pour produire un signal numérique de différence de chrominance $D_Q$ selon la première norme de télévision ; et dans lequel ledit dispositif de sous-échantillonnage (49, 30) comprend un premier sous-échantillonneur (49) pour sous-échantillonner ledit signal de différence de chrominance $D_Q$ pour réduire la fréquence d'horloge d'échantillonnage de celui-ci à $f_S/2$.

14. Appareil selon la revendication 13 dans lequel ledit dispositif d'interpolation (50) augmente la fréquence d'horloge du signal numérique de différence de chrominance à bande réduite $D_Q$ produit selon ladite première norme de télévision à une fréquence d'horloge $f_S$.

15. Appareil selon la revendication 13 dans lequel ledit dispositif de matrice (47, 25, 31) comprend en outre des seconde et troisième matrices (25, 31) pour produire respectivement des composantes numériques de différence de chrominance rouge et bleue à partir desdits signaux numériques d'image de couleur primaire et pour produire un signal numérique de différence de chrominance $D_U$ à partir desdites composantes numériques de différence de chrominance rouge et bleue selon ladite seconde norme de télévision ; et dans lequel ledit dispositif de sous-échantillonnage (49, 30) comprend en outre un second sous-échantillonneur (30) pour sous-échantillonner lesdites composantes numériques de différence de chrominance rouge et bleue à une fréquence de bloc $f_S$ et pour fournir les composantes numériques de différence de chrominance rouge et bleue sous-échantillonnées à ladite troisième matrice (31).

16. Appareil selon la revendication 15 comprenant en outre un dispositif sélecteur (38) pour coupler sélectivement audit dispositif de filtre passe-bas (37, 39) le signal numérique de différence de chrominance sous-échantillonné $D_Q$ lorsque ledit dispositif de filtre passe-bas (37, 39) fonctionne selon ladite première norme de télévision ou le signal numérique de différence de chrominance sous-échantillonné $D_U$ lorsque ledit dispositif de filtre passe-bas (37, 39) fonctionne selon ladite seconde norme de télévision.

17. Appareil selon la revendication 15 dans lequel ladite troisième matrice (31) est utilisable pour produire des signaux supplémentaires de différence de chrominance $D_I$ à partir desdites composantes numériques de différence de chrominance rouge et bleue selon ladite première norme de télévision et des signaux supplémentaires de différence de chrominance $D_V$ à partir desdites composantes numériques de différence de chrominance rouge et bleue selon ladite seconde norme de télévision ; et comprenant en outre un second dispositif numérique de filtrage passe-bas (37) couplé à ladite troisième matrice (31) pour réduire la bande de fréquence des signaux supplémentaires de différence de chrominance $D_I$ et $D_V$ produits par ladite troisième matrice (31) en fournissant une première atténuation prédéterminée à une première fréquence du signal supplémentaire de différence de chrominance $D_I$ et une seconde atténuation prédéterminée à une seconde fréquence du signal supplémentaire de différence de chrominance $D_V$, les signaux supplémentaires de différence de chrominance à bande réduite $D_I$ et $D_V$ étant couplés audit dispositif de modulation (43).

18. Appareil selon la revendication 17 comprenant en outre un dispositif sélecteur supplémentaire (41) pour coupler sélectivement audit dispositif de modulation (43) le signal supplémentaire de différence de chrominance $D_I$ lorsque le dispositif de filtre passe-bas numérique mentionné en premier (37) fonctionne selon ladite première norme de télévision et le signal supplémentaire de différence de chrominance $D_V$ lorsque ledit dispositif de filtre passe-bas numérique mentionné en premier (37) fonctionne selon ladite seconde norme de télévision.

19. Appareil selon la revendication 15, comprenant en outre un dispositif de réglage de niveau (28) couplé pour recevoir les composantes numériques de différence de chrominance rouge et bleue pour établir des valeurs de quantification prédéterminées pour représenter des niveaux de référence respectifs des composantes numériques de différence de chrominance rouge et bleue pour lesdits signaux vidéo numériques à composantes séparées ou numériques composites produits selon ladite première ou ladite seconde norme de télévision.

20. Appareil selon la revendication 19 comprenant en outre un dispositif d'association (11) pour associer lesdits signaux numériques d'image de couleur primaire pour produire un signal numérique de luminance pour lesdits signaux vidéo numériques à composantes séparées et numériques composites.

21. Codeur commun (8) pour une caméra de télévision en couleur utilisable selon des première ou seconde normes de télévision pour coder sélectivement des signaux numériques d'image de couleur primaire à une fréquence d'horloge d'échantillonnage en signaux vidéo numériques à composantes séparées ou numériques composites, ledit codeur comprenant :

un dispositif de génération de signal de luminance (11) pour associer les signaux numériques d'image de couleur primaire pour générer des signaux de luminance à partir de ceux-ci ;
un dispositif de réglage de niveau (13) pour établir des valeurs de quantification prédéterminées pour ledit signal de luminance pour représenter des niveaux de référence respectifs des signaux vidéo numériques à composantes séparées et numériques composites lorsque la caméra de télévision en couleur fonctionne selon ladite première ou ladite seconde norme de télévision ;
un dispositif de matrice (25) pour associer les signaux de luminance et au moins ceux prédéterminés desdits signaux numériques d'image de couleur primaire pour produire des composantes de différence de chrominance à ladite fréquence d'horloge d'échantillonnage ;
un premier dispositif de signal de différence de chrominance (31) couplé pour recevoir et produire sélectivement à partir des composantes de différence de chrominance des premiers signaux numériques de différence de chrominance selon ladite première ou seconde norme de télévision ;
un premier dispositif de sous-échantillonnage (30) pour fournir aux premiers signaux numériques de différence de chrominance une fréquence d'horloge réduite par ladite fréquence d'horloge d'échantillonnage ;
un premier dispositif de filtre passe-bas (37) pour réduire la bande de fréquence de ceux sélectionnés des signaux de différence de chrominance de première fréquence d'horloge réduite dans lesdites première et seconde normes de télévision ;
un second dispositif de signal de différence de chrominance (47) pour associer les signaux numériques d'image de couleur primaire pour générer un signal numérique de différence de chrominance prédéterminé selon ladite première norme de télévision ;
un second dispositif de sous-échantillonnage (49) pour sous-échantillonner le signal numérique de différence de chrominance prédéterminé à une fréquence d'horloge inférieure à ladite fréquence d'horloge d'échantillonnage ;
un second dispositif de filtre passe-bas (39) pour réduire la bande de fréquence soit du signal numérique de différence de chrominance prédéterminé sous-échantillonné soit d'un des signaux numériques de différence de chrominance de la fréquence d'horloge réduite produit selon ladite seconde norme de télévision ; et
un dispositif de modulation (43) pour moduler une sous-porteuse avec les signaux de différence de chrominance à bande réduite fournis par lesdits premier et second dispositifs de filtre passe-bas (37, 39) utilisé dans ledit signal vidéo numérique composite.

22. Codeur selon la revendication 21 comprenant en outre un second dispositif de réglage de niveau (28) pour établir des niveaux de quantification desdites composantes de différence de chrominance produites par ledit dispositif de matrice (25).

23. Codeur selon la revendication 22 dans lequel les valeurs de quantification prédéterminées pour ledit signal de luminance représente 0% et 100% et dans lequel les niveaux de quantification desdites composantes de différence de chrominance représentent 0%, +100% et -100%.

24. Codeur selon la revendication 23 dans lequel les valeurs de quantification prédéterminées pour ledit signal de luminance représentent en outre un niveau de pointe de synchronisation.

25. Codeur selon la revendication 21 dans lequel lesdites composantes de différence de chrominance et ledit signal de luminance comprennent le signal vidéo numérique à composantes séparées.

26. Codeur selon la revendication 25 dans lequel ledit premier dispositif de signal de différence de chrominance (31) comprend un second dispositif de matrice (31) et un premier dispositif de sous-échantillonnage (30) est raccordé audit dispositif de matrice mentionné en premier (25) pour fournir des composantes de différence de chrominance sous-échantillonnées audit second dispositif de matrice (31).

27. Codeur selon la revendication 26 dans lequel ledit second dispositif de matrice (31) produit des signaux numériques de différence de chrominance I selon ladite première norme de télévision et des signaux numériques de différence de chrominance U et V selon ladite seconde norme de télévision ; et dans lequel ledit premier dispositif de filtre passe-bas (37) est raccordé pour recevoir lesdits signaux numériques de différence de chrominance I ou V lorsque la caméra de télévision en couleur fonctionne respectivement selon ladite première ou seconde norme de télévision.

28. Codeur selon la revendication 27 dans lequel ledit second dispositif de signal de différence de chrominance (47) comprend un troisième dispositif de matrice (47) pour produire des signaux numériques de différence de chrominance Q ; et dans lequel ledit second dispositif de filtre passe-bas (39) est raccordé pour recevoir lesdits signaux numériques de différence de chrominance Q ou U lorsque ladite caméra de télévision en couleur fonctionne respectivement selon ladite première ou seconde norme de télévision.

29. Codeur selon la revendication 28 dans lequel ledit second dispositif de sous-échantillonnage (49) sous-échantillonne la fréquence d'horloge dudit signal numérique de différence de chrominance Q de $2f_S$ à $f_S/2$.

EP 0 507 450 B1

FIG.1

FIG.2

# FIG. 3 (A)

IMAGE OUTPUT SIGNAL
(SR· SG· SB· )

# FIG. 3 (B)

INTERPOLATED
COLOR SIGNAL
( D R·· D G·· D B·· )

# FIG. 3 (C)

LUMINANCE SIGNAL (DY··)
COLOR DIFFERENCE(DI·
SIGNAL DQ·)

# FIG. 3 (D)

FILTER OUTPUT OF
COLOR DIFFERENCE
( DI· DQ· )

# FIG. 3 (E)

MODULATED COLOR
DIFFERENCE SIGNAL
(MOD.C·)

# FIG. 3 (F)

INTERPOLATING FILTER
CHARACTERISTICS

# FIG. 3 (G)

MODULATED COLOR
DIFFERENCE SIGNAL
(MOD.C··)

# FIG. 3 (H)

COMPOSITE
VIDEO SIGNAL
( DS·· · )

**FIG.4(A)**
IMAGE OUTPUT SIGNAL
(SR. SG. SB. )

**FIG.4(B)**
INTERPOLATED
COLOR SIGNAL
(DR.. DG.. DB.. )

**FIG.4(C)**
LUMINANCE SIGNAL (DY..)
COLOR DIFFERENCE(DV.
SIGNAL        DU.)

**FIG.4(D)**
FILTER OUTPUT OF
COLOR DIFFERENCE
(DV.DU. )

**FIG.4(E)**
MODULATED COLOR
DIFFERENCE SIGNAL
(MOD.C.)

**FIG.4(F)**
INTERPOLATING FILTER
CHARACTERISTICS

**FIG.4(G)**
MODULATED COLOR
DIFFERENCE SIGNAL
(MOD.C..)

**FIG.4(H)**
COMPOSITE
VIDEO SIGNAL
(DCS.. )

**FIG.5**

**FIG.6**

**FIG.7**

**FIG.8**

**FIG.9**

**FIG.10**

EP 0 507 450 B1